# EUROPEAN PATENT SPECIFICATION

(11) **EP 0 410 502 B1**
(45) Date of publication and mention of the grant of the patent: **28.05.1997**
(21) Application number: 90201869.6
(22) Date of filing: 11.07.1990
(51) Int. Cl.: G06F 17/50

(54) **Method and apparatus for emulating interaction between application specific integrated circuit (asic) under development and target system**
Methode und Gerät zur Wechselwirkung-Emulation zwischen einer anwendungsspezifischen integrierten Schaltung (ASIC) während der Entwicklung und ein Zielsystem
Méthode et appareil pour émuler l'interaction entre un circuit intégré d'application spécifique (ASIC) en développement et un système de destination

(30) Priority: 27.07.1989 US 386332
(43) Date of publication of application: 30.01.1991
(73) Proprietor: LSI LOGIC CORPORATION, Milpitas, CA 95035 (US)
(72) Inventor: Watkins, Daniel R., Los Altos, CA 94022 (US)
(74) Representative: Fieret, Johannes, Ir.

(56) References cited:
- GB-A- 2 138 605
- US-A- 4 901 259
- RESEARCH DISCLOSURE no. 278, June 1987, NEW YORK US page 362 'emulation system employing a logic entity during design simulation'
- VLSI SYSTEMS DESIGN vol. 9, no. 7, July 1988, pages 30 - 98 WIDDOES ET AL 'hardware modeling'

## Description

### 1. Field of the Invention

This invention relates generally to the development of integrated circuits and more specifically to a method and apparatus for developing digital, application specific integrated circuits (ASIC's) which are to be inserted into a complex target board or system.

### 2. Description of the Relevant Art

The logic density of digital integrated circuits has increased nearly tenfold every decade since their introduction. In the 1960's, the typical digital IC (integrated circuit) was fabricated with perhaps no more than six to twelve basic logic gates defined in its substrate. Logic density increased to approximately one hundred gates per IC chip in the decade of the 1970's, to one thousand logic gates in the early 1980's, and has already reached one hundred thousand logic gates per integrated circuit in the late 1980's. Gate densities on the order of one million logic cells per chip are predicted for the 1990's.

Concomitant with this increase, the functional complexity of the digital circuits that are provided on each IC has increased in similar fashion. The numbers of sum-of-product terms or product-of-sums terms that could be provided on a single chip and the intricacy of interconnections between the combinatorial logic circuits of a digital IC, if such could be quantified, have also increased.

The process of designing and developing a high density IC has become more complicated as well. Because of the complexity of such IC's, it is becoming increasingly difficult for chip designers to produce a prototype IC which operates correctly on a first run attempt (on the casting of "first silicon"). Functional flaws in so-called "first silicon" prototypes tend to occur at a rate in excess of fifty percent of all prototypes. Every flaw has to be found and corrected. Fault identification and correction lengthens the time of the design and development process undesirably. There is need within the industry to minimize such time.

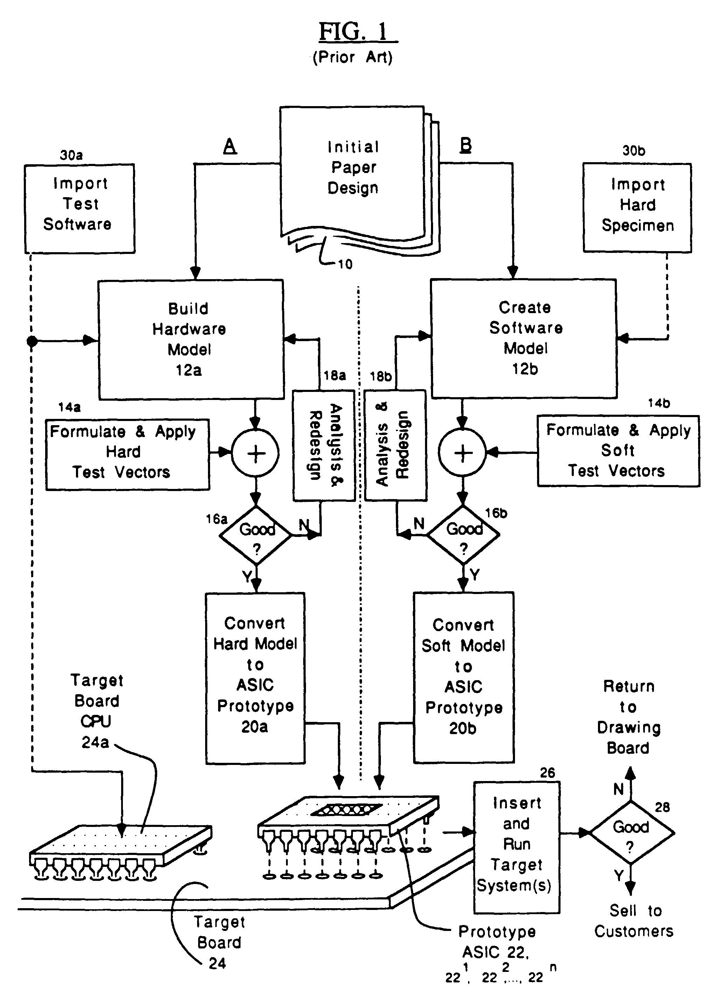

The design and development process usually revolves about a development "model", which is either a hardware or software model of the yet-to-be developed ASIC. Two traditional methods, A and B, for developing an application specific integrated circuit (ASIC) are charted in parallel in the flow diagram of Fig. 1.

The first of these methods, A, which may be referred to as the "hardware breadboarding" method or the "hardware modeling" method, has its origins in the very early days of integrated circuit technology; in the years when so-called "small scale integration" (SSI) circuits were first being developed. An initial paper design, description or "specification", 10, of the desired integrated circuit is drafted and the ideas within that draft design 10 are converted into an initial hardware model 12a using discrete components, such as individual transistors, resistors, etc., and even previously developed integrated circuit chips. The step of building this hardware model is schematically illustrated as step 12a in Fig. 1. A set of test signals, which may be referred to as "hardware" test vectors, are then devised and generated (using a suitable signal generator) as indicated at step 14a, and applied to the hardware model 12a in order to determine whether it performs in accordance with the specifications of the initial paper design 10.

At least in the early years of integrated circuit technology, when the level of integration was such that it could be referred to as being either small scaled (SSI) or medium scaled (MSI), it was common for design engineers to manually develop a set of test vectors in an ad hoc manner, without the aid of a computer, and use these test vectors to verify the logical correctness of the hardware model 12a. Manual test vector formulation is preferred in some cases, even today, despite the complexity of higher density MSI, LSI (large scale integration) and VLSI (very large scale integration) chips being produced presently. For the most part, test vectors are formulated with the aid of computers, using so-called computer aided engineering (CAE) software. The software is expected to generate a "complete" set of test vectors for verifying the logical correctness of the hardware model 12a. The term "complete" is intended to signify here that all possible input combinations are applied to the input terminals of the hardware model 12a and that the model's responses to all these combinations are monitored and analyzed to assure that each response is in accordance with the specifications 10. The hardware model is typically constructed on a test-bed which includes automated test signal generation means and response monitoring means incorporated therein for testing the hardware model 12a. The monitoring means often includes a digital oscilloscope or logic analyzer and a plurality of test points in the hardware model to which probe leads of the logic analyzer can be connected.

If the initially built, hardware model 12a fails to pass any of the test sequences formulated by the design engineers (at step 16a), the reason for the failure is determined by probing various test points within the hardware model 12a (using for example, a digital oscilloscope and a digital logic analyzer); determining why and how the logic fault arose, and redesigning (step 18a) the hardware model 12a to correct the problem. The reconfigured hardware model 12a is then subjected to generally the same set of test vectors 14a and the fault detection (16), analysis and redesign (18a) steps are repeated until the once, twice or m-times reconfigured hardware model 12a^{m} passes all the test sequences 14a that had been formulated by the design engineers (m is an integer representing the number of times that the hardware model is reconfigured). The steps of building and reconfiguring the model 12a, formulating test vectors 14a, testing 16a, analysis and redesign 18a constitute an "inner" loop of the design/development process A.

Once the hardware model 12a is deemed "good" at testing step 16a, an "outer" loop of the design/development process A begins. The circuit design of the m-times reconfigured hardware model 12a^{m}, as thus far developed, is transformed into a detailed "transistor level" schematic. (The transistor level schematic shows each individual transistor or other primitive component of the hardware-modeled circuit.) A circuit in accordance with the transistor-level schematic is laid out and patterned into a semiconductor substrate at step 20a to thereby form a "first run" prototype integrated circuit 22 ("first silicon"). The step 20a of converting the hardware model 12a^{m} into a prototype integrated circuit 22 is usually tedious, time consuming and costly. Care must be taken to assure that the circuitry of the ASIC prototype 20a accurately duplicates the circuitry of the developed model 12a^{m}. The probability for error tends to increase as the number of logic gates in the model 12a^{m} rises.

The prototype integrated circuit 22 is inserted into a target circuit board 24, power is applied to the target board 24, (the design engineers close their eyes and pray that the prototype ASIC does not immediately explode upon application of power), and if the power-up step is successful, the board 24 is exercised and tested at steps 26 and 28 to determine whether the prototype 22 is ready for market.

If an operational fault is detected at this outer-loop phase of product development, after the "first run" ASIC prototype 22 has been fabricated, it is usually necessary to return to the inner loop of the development process A and determine therefrom the cause of the fault. It is often times too difficult to probe all necessary points within the first run ASIC prototype 22 to locate the source of the fault. An attempt is made from within the inner loop (steps 14a, 16a, 18a, 12a) to recreate in the hardware model 12a^{m} the failure mode of the outer loop (steps 20a, 26 and 28). A new set of test vectors 14a is formulated and these are applied to the hardware model 12a^{m}. Test points within the hardware model 12a^{m} are again probed. Analysis and redesign (18a) of the hardware model follows. When the testing step 16a indicates that the fault has been eradicated, a "second run" integrated circuit prototype 22' is fabricated (step 20a) and inserted (26, 28) into the target board 24. The outer and inner loops of the fault identification/correction process (A) are repeated until the resultant second, third or subsequent n-th run integrated circuit prototype 22ⁿ meets all the tests formulated by the development engineers. At this point, sample copies of the n-th run prototype ASIC 22ⁿ are distributed into the marketplace for testing and acceptance by various "betasite" customers.

As the density of digital IC's has increased further and further, the step of building a hardware prototype model 12a became too cumbersome. IC's were becoming too dense for physical modeling with discrete components. Luckily, the art of simulating a digital circuit in software was becoming sufficiently advanced so that the hardware-modeling step 12a, testing steps 14a and 16a, analysis and redesign step 18a could all be replaced with corresponding steps (12b, 14b, 16b, and 18b) in a much more flexible software modeling method B.

The software modeling method B parallels the hardware modeling method A and is accordingly drawn side by side with the hardware modeling method in Fig. 1 for convenient comparison. It should be noted that, aside from their parallel structures and a common starting point (the initial design 10), there is no link between the hardware and software modeling methods, A and B. The latter method, B, comprises the steps of creating a suitable software model 12b within a simulation program environment, formulating software test vectors 14b which are to be applied to the software model 12b, testing 16b the entire model in the simulation program environment, probing all necessary test points within the software model 12b using suitable software debugging tools, and redesigning (18b) the software model 12b until all software generated tests are passed at step 16b.

When the m-times reconfigured software model 12b^{m} is deemed "good" at step 16b, a network list (CAD/CAM list) of all the elements and interconnections within the software model 12b^{m} is generated and the generated list is converted into a hardware, prototype ASIC 22 at step 20b. The process described before, of inserting the first-run prototype ASIC 22 into a target board 24 and testing the same, is repeated until either the first or a subsequent n-th run, prototype ASIC, 22ⁿ meets all the tests formulated by the developers of the integrated circuit.

The software modeling method B is usually preferred over the hardware modeling method A. Physical size of the model is no longer a problem. Simulation computers can usually be provided with sufficient (virtual) memory capacity to simulate the most complex of proposed integrated circuits. Changes to the software model (redesign 18b) can be made much more quickly than corresponding changes to a hardware model 12a. The time for developing a prototype ASIC 22 using the software method B can thus be made significantly shorter than that of the hardware breadboarding method A. The step 20b of converting the software model 12b into a silicon prototype 22 is preferably automated to reduce errors in the conversion process and avoid some of the attendant tedium of such conversion. The software modeling approach, B, can be accordingly structured to overcome many of the physical problems associated with developing high density IC's. But that is not enough. As logic density increases further and further, a new problem has begun to emerge in the industry.

When gate densities begin to surpass the 1000 gates per chip level, it is found that even with the software approach B, approximately fifty percent or more of the time, the first run prototype ASIC 22 contains at least one logic fault which the test vectors formulated at step 14b had failed to catch; despite the best efforts of the design engineers to formulate a "complete" set of test vectors. The number of input signal combinations which could be applied to the ASIC 22 in real world applications begins to grow exponentially in relation to gate density. It becomes physically impossible to test "all" the combinations.

Design engineers try to make educated guesses about what sets of input combinations are most likely to be applied to real world situations. But this is the best that could be said about the completeness of the test vectors, that it is based on educated speculation. Hopefully, if a fault is missed at the inner loop testing step 16b, it is caught during in-house (alpha) testing of the prototype 22 when that prototype is combined with a target board 24 and tested again at step 28. The process of determining the cause of a logic fault detected at testing step 28, of tracing it back to an appropriate portion within the software model 12b, of analyzing, redesigning 18b, and converting the m-times modified software model 12b^{m} into a second run prototype chip 22' remains the same as previously described for the hardware modeling method, A. The outer and inner loops of the software development process, B, including the software-to-hardware conversion step 20b, are repeated until all in-house ("alpha") tests are successfully passed.

If one or more logic faults is missed in the alpha-testing phase it is hopefully caught by "beta" test customers. These are usually sophisticated outsiders who are given samples of the n-th run prototype 22ⁿ for testing in unique, application-specific target systems. In the worst case scenario, a logic fault is not found either during alpha-testing or beta-testing, but rather much further down the product development cycle, by general-use customers who find unexpected "bugs" in the operations of the ASIC, after the final run ASIC 22ⁿ, is already distributed throughout the market. This is something that high density ASIC developers fear the most and wish to avoid at all cost. Replacing "bug" ridden ASIC's with corrected ones can be extremely expensive. Once stung customers tend to lose faith in new technology and/or the developer if the replaced products are again riddled with "bugs". If there is no means for reliably catching major faults within a high density chip during in-house "alpha" testing, developers begin to shy away from high density designs. This avoidance slows advancement of the art. It is a problem which needs to be solved in the industry if the gate density of IC's is to continue climbing upwardly as it has in the past.

There is yet another problem which has begun to emerge within the industry. As the gate densities of digital IC's continue to increase, it is found that the step 20b of converting the software model 12b into a prototype IC 22 is becoming increasingly longer. The model to prototype conversion step is becoming a major roadblock to shortening design and development time. If design/development time is too long, a critical market window might be missed.

Some in the industry have been attempting to speed up the conversion process 20b in order to shorten design/development time. But this approach misses the source of the problem. The true root of the problem lies, not at the back-end software-to-hardware conversion step 20b, but at the front-end step 14b, where design engineers are asked to formulate a "complete" set of test vectors for assuring that the fabricated prototype ASIC 22 will perform as desired in the target system board 24. There is no coupling between the software-based, inner design loop (steps 12b, 14b, 16b and 18b) and the target system 24 into which the first run prototype 22 is to be inserted. Thus incompatibility between the target system 24 and the ASIC design (model 12b) cannot be discovered until after the prototype 22 is fabricated. The present invention provides such coupling and thus overcomes the problem as will be seen shortly.

Before explaining the invention, however, it will be beneficial to understand why coupling between the model and the target system could be advantageous. The complexity of target systems 24 has been increasing steadily and concomitantly with increases in the complexity of high density ASIC's. It is becoming extremely difficult for design engineers to assure, prior to the prototype fabrication step 20b, that they have formulated a "complete" set of test vectors at step 14b. Ideally, a "complete" set of test vectors should be one which simulates in software all possible interactions between the ASIC and all possible target systems 24 so that all possible failure modes of the ASIC-under-development can be detected and eradicated before a prototype ASIC 22 is fabricated. But present day target systems are so complex, that it is nearly impossible to foresee all interactions that could develop between an ASIC and its target system.

By way of example, the target system 24 could be a complex "open-architecture" microcomputer built around a state-of-the-art central processing unit (CPU) 24a. Such open-architecture target systems 24 add a new dimension to the test vector formulating step 14b. Open-architecture target systems 24 are expandable. This means that new hardware or software, which is often provided by parties other than the ASIC developer, can be added to the target system 24 to expand its capabilities. It is extremely difficult for in-house test engineers of one ASIC developer to determine what will constitute a "complete" set of test vectors at step 14b when they do not possess full knowledge of the expansion hardware and/or software of other hardware/software developers (third party vendors).

The problem of insufficient information is expected to become worse as time goes on and more complex target systems are devised. The information gap at the in-house testing stage is expected to widen. A method and/or apparatus which reduces the information gap or makes the same inconsequential during the design and development process is much needed in the industry.

Alongside the above described problem of formulating a complete set of test vectors for complex (i.e., expandable) target systems, another problem has also begun to emerge in the industry. Quite often, it is impossible to obtain a complete specification for all the components in the target system 24 even if the design of the target system is fixed (nonexpandable). By way of example, the target system 24 may include a so-called "complex third generation" microprocessor 24a such as the 68030™ which is produced exclusively by Motorola Corp. of Austin, Texas or the 80386™ which is produced exclusively by Intel Corp. of Santa Clara, California. It is extremely difficult to fully simulate all the operating modes of such proprietary microprocessors in the software environment of the software ASIC model 12b. Accordingly, there is substantial danger that the test vectors formulated at step 14b by in-house design engineers for simulating such proprietary devices will not be "complete". If the test vectors are not complete, then it can not be known with certainty at the inner-loop testing step 16b, whether the yet-to-be fabricated ASIC prototype 22 will be compatible with the propriety design of the target board CPU 24a.

Another problem is that all the fine-detail operating characteristics of the yet-to-be developed ASIC may be unknown when the inner development loop is initiated. By way of example, the initial specification 10 may call for inclusion within the not-yet-developed ASIC 22 of a macrocell equivalent of a proprietary chip, produced by a third party vendor. It is possible that the vendor of the proprietary IC chip has not provided a full specification of its chip and thus it cannot be accurately simulated in software. Even if full specifications are provided, there are cases where software simulation of such devices may require many man-hours of programming, many lines of program code, and the danger becomes greater, as the lengths of the programming time and/or simulation code size increases that the resultant software simulation will contain a flaw.

It has been proposed that the operating characteristics of a hardware specimen 30b of a not-fully-understood, but already-developed, device should be imported into the software environment of the software ASIC model 12b in order to overcome this information gap. One method for such importation is disclosed in U.S. Pat. 4,590,581, entitled "Method and Apparatus for Modeling Systems of Complex Circuits", which issued May 20, 1986 on an application filed by L.C. Widdoes, Jr. on May 9, 1983 (hereafter the "Widdoes' Patent").

In brief, the Widdoes patent proposes to insert a pre-developed "reference element" (hardware specimen) into a general-purpose support-jig and to construct a special interface circuit, referred to as a "personality module", for receiving input-stimuli from the software simulation environment, transmitting those input stimuli to the already-developed reference element, receiving responsive output signals from the reference element and transmitting those responsive output signals back to the software simulation environment.

This proposal of Widdoes overcomes the problem of having to construct software simulation models for developed IC's whose complex operations are either not fully known or are too difficult to simulate entirely by software. The Widdoes method does not, however, provide a solution for the earlier discussed problem, namely, how to formulate a complete set of test vectors which will assure that the software model 12b of an ASIC device, that is still under development, will be exposed to all possible stimuli that could be generated by a complex target system 24. There is no coupling between the IC importation method disclosed in the Widdoes patent and the target system 24. For completeness of the above-described software modeling approach B, the Widdoes importation method is indicated as step 30b in Fig. 1.

In conjunction with the Widdoes method, it should be mentioned that a parallel approach exists in the hardware method A. Test software can be imported into the hardware environment of the hardware model 12a. This is indicated by step 30a in Fig. 1. A so-called "in-circuit CPU emulator", which is a device that emulates the operations of a complex, pre-developed microprocessor, is inserted into either the target board 24, in place of a controlling CPU 24a, or into a general purpose test-bed supporting the breadboard model 12a. The in-circuit CPU emulator functions as a "black box" equivalent of the replaced CPU, and additionally, provides the user with the ability to set software controlled break-points, inject software-controlled test signals into the target board 24 through the CPU-emulating device, and to examine internal states of the emulated CPU.

In-circuit CPU emulators are available, by way of example, from Intel Corp. of California. One example is the ICE-86™ In-Circuit Emulator of Intel which emulates the Intel 8086™ microprocessor. Descriptions of in-circuit emulators may be found by way of further examples, in U.S. Pat. No. 4,674,089, "In-Circuit Emulator", which issued June 16, 1987 on an application filed by Poret, et al; U.S. Pat. No. 4,621,319, "Personal Development System", which issued Nov. 4, 1986 on an application filed by Braun, et al; and U.S. Pat. No. 4,084,869 "Interconnector For Integrated Circuit Package", which issued April 18, 1978 on an application filed by Yen. The disclosures of these patents are incorporated herein by reference.

The in-circuit emulator approach 30a does not provide the ASIC design engineers with a means for either interrupting the internal operations of the hardware model 12a or for monitoring the logic states of internal points within the hardware model 12a. Thus, it does not provide the same degree of flexibility afforded by the software modeling method B. Moreover, because of its primarily hardware nature, and its dedication to a specific pre-designed CPU, the in-circuit emulator approach 30a does not provide ASIC development engineers with a convenient, general-purpose means for formulating a "complete" set of test vectors at step 14, in order to assure complete compatibility between different target systems 24 (which could comprise different CPU's 24a and other complex components) and the resulting prototype ASIC 22.

In summary, the generation of a "complete" set of test vectors for assuring compatibility between the ASIC-under-development and one or more complex target systems remains a problem in the industry. Neither the Widdoes method of importing a hard specimen 30b into the software simulation environment of the software model 12b nor the in-circuit CPU emulator method 30a of importing test software into the target board via a pre-developed CPU overcomes the problem of how to assure that a full spectrum of test vectors will be applied to either the hardware model 12a or the software model 12b of the ASIC prototype 22 before the modeled circuit is "cast in silicon" (converted into a prototype IC) at either of steps 20a and 20b. There is need in the industry for a method of formulating a more complete set of test vectors and assuring compatibility with different target systems.

A respective method is known from GB-A-2 138 605. According to this document, a clear definition of the interface to an existinq target system is achieved by inserting an assembly of real pins ("pin-dummy") into the IC-receiving socket of a target system. Logical states of the software-simulated output-pins (virtual pins) defined in a soft model of the IC to be designed are projected into the target system through corresponding pins of the pin-dummy, thereby causing such software states to become hardware type stimuli for the target system.

Logical states of the target driven real pins of the pin dummy are reciprocally duplicated in the soft model by projecting such target-produced states (target responses) into the software model through virtual input pins, thereby causing these states to become simulation stimuli.

Such mirroring of pin states in the respective environments of the target system and the software model enabling the testing of all possible interactions between the IC model and its target system.

### SUMMARY OF THE INVENTION

It is an object of the present invention to overcome the shortcomings of the prior art and to provide a method for exposing either a software model (hereafter "soft model") or a hardware model (hereafter "hard model") or a combination soft/hard model (hereafter "hybrid model") of an integrated circuit under development (hereafter "ICUD") to a rich spectrum of test vectors similar to the vectors that the final production device (the n-th run prototype ASIC) will be exposed to when finally inserted into a target system. The soft, hard and hybrid models are each generically referred to here as the "ASIC model."

A method according to the invention is set out in claim 1.

In accordance with one aspect of the present invention, an assembly of physical pins or "real" pins (which assembly may hereafter be referred to as a "pin dummy") is inserted into the ASIC-receiving socket of a target system. Logical states of software-simulated output-pins ("virtual" output pins) defined in a soft model of the ICUD are reproduced in the physical hardware of the target system by projecting such logical output-pin states of the ICUD model (i.e., so-called ASIC-responses) into the target system through corresponding "real" output-pins of the pin dummy, thereby causing such software states to become hardware-type "target-stimuli" which stimulate the target system hardware (and target system software) into entering a state responsive to the soft-model produced stimulus. Logical states of target-driven "real" input-pins of the pin dummy are reciprocally duplicated in the soft model by projecting such target-produced states (target-responses) into the soft model through corresponding software-simulated input-pins ("virtual" input pins) of the soft model, thereby causing these states to become "ASIC-stimuli" which stimulate the soft model into entering a reciprocal state responsive to the target-produced states.

When such stimulus/response exchanges take place, the pin dummy emulates the function of the ASIC-target interconnecting pins that will be provided on the chip package of the not-yet-fabricated integrated circuit prototype (PIC). From the view point of the target system, it will appear that a physical ASIC prototype (PIC) is already plugged into its ASIC-receiving socket. From the view point of the soft model, it will appear that a "complete" software emulated version of the actual target system has been correctly programmed into the software simulation environment (the hardware "platform" or "support" computer) of the soft model.

Such mirroring of pin states in the respective hardware/software environments of the target-system/soft-model enables the testing of all possible interactions between the ASIC model and its target system. The reciprocal duplication of input/output states at the respective real/virtual pins of the target-system/soft-model creates tight coupling between the target system and the soft model (ASIC model). This tight coupling gives ASIC developers the opportunity to quickly uncover and correct most of the incompatibilities which could exist between the ASIC under development and the target system, long before a prototype of the ICUD is fabricated. Substantial savings in development time and cost can be realized from such a development environment.

A pin dummy can take many forms. It could be a dummy package (probe head) of substantially identical form to the actual package which will house the PIC, with an umbilical cable extending therefrom to operatively couple the real pins of the pin dummy to a virtual pin register (to be described later) in which the states of virtual pins are stored. The pin dummy could otherwise be a set of separate connectors that are each connected to a target system connection point which will ultimately be coupled to a corresponding pin of the not-yet-fabricated prototype IC (PIC). The pin dummy could further be an integral portion of a "pin dummy IC" where the latter integrated circuit comprises a monolithic substrate packaged in a package similar to that of the not-yet-fabricated prototype PIC and further where the latter pin dummy IC is provided, on the semiconductor substrate thereof, with suitable tristate drivers coupled to the real pins of the pin dummy, real-pin register means coupled to the tristate drivers for storing data that is received from or transmitted to the real pins, and serial to parallel conversion means coupled to the real-pin register means for converting data stored in the real-pin register means from parallel to serial form (and vice versa).

Input-pin signals (ASIC-stimuli) which are presented by the hardware of the target system in parallel form to signal-receiving input-pins ("real" input pins) of the pin dummy are preferably converted into serially transmittable input bits and and these are serially transmitted to a soft-model memory means (i.e., to a virtual pin register) which is supporting the software-simulated input-pins ("virtual" input pins) of the soft model. The serially received input bits are then preferably converted into parallel form i.e., by shifting into the virtual pin register) and presented in such parallel form to the virtual input pins of the soft model.

Output pin states (target-stimuli) produced by the soft model (at other virtual pins thereof) are correspondingly converted into serially transmittable output bits and these are serially transmitted to the real-pin register means. The serially received output bits are converted into parallel form and preferably first stored as such in a real-pin buffer register means. Once a predetermined number of output bits are so received and stored in the real pin buffer register means, the stored output bits are transmitted in parallel form to the real pin register means and from there to the pin dummy in a suitable manner so as to simultaneously drive "real" output-pins of the pin dummy to electrical states representing the output pin states produced by the soft model.

The exchange of virtual and real input/output pin state information between the target system and the ASIC model supporting platform (i.e., a workstation) may occur in either real time or pseudo-real time fashion. When the pseudo-real time signal-exchange approach is utilized, the target system is either single stepped at a rate slower than its natural speed or the clock of the target system is slowed in such manner so as to keep the target system in synchronism with an otherwise slower-running ASIC model (i.e., a soft model). When the real time approach is taken, the target system is allowed to run at full speed and the hardware platform of the ASIC model (i.e., the computer hardware that is supporting the soft model) is operated at sufficient speed to permit the ASIC model to keep pace with the clock of the target system. In either case, the simulation of the ICUD by a soft model and the exchange of virtual/real states should be conducted at sufficient speed to allow at least 1,000 bits per second of stimulus/response information to pass through the virtual/real pin mirroring arrangement so that real-time or "almost real-time" ASIC/target interaction can be observed. The term "almost real-time" is intended to mean here that, within a reasonable amount of observation time (i.e., less than three minutes), at least hundreds, if not thousands or millions, of sequential bytes should be exchanged between the ASIC model and the target system. The cycle period for virtual/real pin information exchange (stimulus and response) between the ASIC model and target system should preferably be on the order of less than one millisecond and even more preferably on the order of less than one microsecond. Such short transaction durations should permit designers to observe within relatively short time, the tightly coupled interactions of an ASIC model and either a deterministic or nondeterministic target system. By "nondeterministic" it is meant that a system does not necessarily produce the same result time after time. The stimulus-response times of the latter, nondeterministic target systems, should be equal to or greater than the stimulus-response time of the ASIC model in combination with the pin state mirroring means if nondeterministic interaction is to be observed.

It is to be understood here that no first/second ordering is implied by the use above of the paired terms, "ASIC-stimuli"/"target-response" or "target-stimuli"/"ASIC-response". These terms merely indicate a bidirectional cause/effect relationship between the input/output signals of the ASIC model and the corresponding output/input signals of the target system. The question of which comes first, ASIC-stimuli or target-stimuli, is a matter of choice dependent on the design of a specific ASIC/target combination and this is left to the designers.

In accordance with a second aspect of the invention, the ASIC model is configured to include both a soft model portion and a hard model portion (i.e., the ASIC model is formed as a combination of a soft model of one part of the ASIC design and as a hard model of another part of the ASIC design; that is, the ASIC model is a hybrid model).

First software information, defining specific hardware logic components (i.e., AND gate, OR gate, inverter, flip-flop, multiplexor, etc.) that are to be used in the hard model portion and further defining signal routing lines (i.e., connections between input/output nodes of the logic components) that are to be formed in the hard model portion, is transmitted to an array of programmable logic devices (PLD's) to configure the PLD array into circuitry which emulates in hardware the so defined hard model portion of the ASIC model. The PLD array is preferably coupled to a target system directly by a pin dummy but the former can also be coupled to the latter by means of a virtual-pin/node-register to real-pin-register mirroring arrangement, the virtual virtual-pin/node-register being a memory means which supports virtual pins and/or virtual nodes of a programmably definable ASIC model (virtual ASIC) as will be described later.

Second software information is further transmitted to the PLD array to define in the PLD hardware an embedded logic analyzer means for monitoring any randomly-addressed node (test point) within the hard model portion of the virtual ASIC. This PLD-implemented hardware-emulation approach is preferably followed for portions of the ASIC model which are to interact at relatively high speed (i.e., cycle times of one microsecond or less) with the target system. The previously described software-simulation approach (where virtual pins or nodes are defined in a soft model) is preferably followed for other portions of the ASIC model which do not need to interact at high speed with the target system.

In accordance with yet another aspect of the invention, a behavioral-level model portion (or the entirety) of the ASIC model is fragmented and mapped into a massively parallel array of processors for simultaneously simulating, by suitable parallel programming, the mapped portions (or the entirety) of the ASIC model in the massively parallel array. The parallel-wise simulated portions of the ASIC model are tightly coupled to a target system via a pin dummy and a virtual-pin-register to real-pin-register mirroring arrangement as will be explained later.

An embedded logic analyzer means is preferably defined within the parallel-processor simulator for monitoring randomly selected nodes (test points) of the ASIC model and for injecting test signals into the same or other desired nodes thereof. A high-speed serial communication link is preferably used to exchange information between real input/output pins of the pin dummy and virtual input/output pins of the ASIC model. Information exchange periods of less than one millisecond are preferred and less than one microsecond even more preferred for each single exchange cycle. Such high speed exchange of real-pin/virtual-pin information creates a real time (or psuedo-real-time) mirror image (equivalency) relationship between the logic states of the real pins in the pin dummy and the logic states of virtual pins that are being simulated by the parallel processor array.

Interactions between the target system and the ASIC model (the latter of which may be simulated/emulated in whole or in part by any one or a combination of: (1) a soft-model simulating array of parallel-processors, (2) a hard-model emulating array of PLD's, and (3) a soft-model simulating von-Neumann style workstation) are then studied and the programmably-defined ASIC model (virtual ASIC) is reconfigured as needed to conform with design goals.

A particular aspect of this invention concerns the fact that often times, the "initial" ASIC model, which is the state of the ICUD design prior to any substantial testing and redesign, is defined at least partly by a behavioral level model (a coarse description of the ICUD). This behavioral level model is converted (refined) step wise during development into a transistor level model (fine detail description of the ICUD) while simultaneously, ASIC "bugs" and incompatibilities between the target system and the ASIC model are uncovered and corrected by redesign.

With respect to such simultaneous refine/debug development methods, it is a feature of the invention that testing, redesign and descriptive refinement of the ASIC model from a coarse descriptional state to a fine descriptional state, are concomitantly carried out using the virtual-pin to real-pin mirroring concept of the invention from the outset of design/development to at least a point in time when the entirety of the ASIC model has been refined down to at least the gate-level. When the ASIC model has so evolved in its entirety to a gate-level state of refinement (or another similar fine-detail descriptive state), all logic-functional incompatibilities between the target system and the ASIC design should be ironed out (as a result of concomitant debugging). Accordingly, when such a state is reached, it should be possible in most instances to immediately proceed with the fabrication of a bug-free prototype IC. The simultaneous use of tightly-coupled debugging and descriptive refinement is expected to substantially reduce the time and cost of design/development relative to previous ASIC development methods.

One finer aspect of the invention which should not be overlooked with regard to the above feature, is that the ASIC design/development method disclosed here provides developers with the ability to flesh out (uncover) incompatibles between target systems and ASIC models even at the initial phase of design/development, before substantial effort is invested in refining the ASIC model from an initially coarse descriptive level to a finer descriptive level. Information (i.e., digital data packets) representing the logic states of "virtual" and "real" pins may be exchanged between a target system and a "coarse-grained" ASIC model before effort is expended to define, in substantial detail, all parts of the ICUD. Coarse-level incompatibilities between a "coarse-grained" ASIC model and its target system(s) can be discovered and corrected before misdirected time and effort is expended to reduce an initial ASIC model from an incompatible coarse-grained definitional state to an equally incompatible fine grained definitional state. Substantial savings in development time should be realized from early resolution of coarse incompatibilities between the ICUD and its target system (or systems).

In accordance with still another aspect of the invention, the software embodied definition of the ASIC model (which definition comprises any or all of the soft model, the configuration data for the PLD array and the interconnect data used for programmably interconnecting two or more of a von-Neumann platform, a massively parallel processor platform and a PLD hardware array one to the other) is fragmented and distributed among a plurality of workstations. The workstations are linked to one another and/or to one or more pin dummies through one or more serial communication networks (i.e. a so-called LAN's [Local Area Networks]) which bring together individual information packets of the plural workstations and channel these packets through the pin dummies to the real pins thereof in such a manner that the logic states of the real pins are caused to be substantially the same as the logic states of virtual interpackage-pins in a network-distributed ASIC model and vice versa. Virtual interpackage-pins are distinguished here from virtual intrapackage-pins. The latter type of virtual pins which will also be referred to later as "fractional nodes" are used for partitioning an ASIC model into fragmented portions (fractions) and for linking the fragmented portions one to another.

When ASIC fractions are each distributed to a different one of individual members of a network-connected array of workstations, and/or an array of parallel processors, the real-time (or pseudo-real time) duplication of states at corresponding "node fractions" (nodes that are split into fractions by the act of partitioning) of each ASIC fragment creates a condition wherein each fragment operates as if it is still directly coupled (either in software or hardware) to another fragment. When the definition (software/hardware description) of an ASIC model is so fragmented, distributed across a network, and recoupled by mirroring the states of corresponding node fractions of each fragment, it becomes possible for one developer to design/develop one part of the ASIC model at a first development site while one or more other developers are simultaneously working on other parts of the ASIC model at a second development site. The combined workproduct of the different developers (each located at a different site) can be joined and tested against a target system (which could be located at yet another site) by interconnecting their respective fragments through one or more virtual-pin/node-register to counterpart (real)-pin-register mirroring arrangements and projecting the states of such pin register combinations (in real or pseudo-real time) into a common target system through one or more pin dummies.

The above and further aspects of the invention may be realized in whole or in part by combining a pin dummy with one or more (network-interconnected) von-Neumann style workstations, an array of PLD's and/or an array of parallel processors. A software configurable interconnect means may be used to programmably join one or more of these model-supporting entities to the pin dummy to thereby define the total design of the ASIC model. Preferably, one or more high-speed serial communication links (each having a set of parallel-to-serial and corresponding serial-to-parallel bit stream conversion means) are used to interconnect the various model-supporting entities (ASIC emulators/simulators) and to thereby minimize the number of wires needed for such interconnection. Information exchange, for causing the logic states of real pins on the pin dummy and the logic states of corresponding virtual pins in the ASIC model to be substantial replicas of one another, occurs through the one or more serial communication links.

In accordance with a first embodiment of the invention, the real-pins of a pin dummy are coupled to an ASIC emulator apparatus comprised of: (a) real input register means having input terminals coupled to one or more target-driven ones of the real-pins for receiving from a target system and storing in memory cells of the real input register means, first digital data representing one or more target-generated input states appearing at the target-driven real-pins, the target-generated states being states which are to be mirrored (duplicated) at software-simulated input-pins (virtual input-pins) of a soft model; (b) real output register means having output terminals coupled to one or more target-driving ones of the real-pins for storing in memory cells of the real output register means and transmitting therefrom to the target system, through the target-driving real-pins of the pin dummy, second digital data representing the states of software-simulated output-pins (virtual output-pins) of the soft model; and (c) direction designating means for designating preselected ones of the real-pins of the pin dummy as target-driving and/or target-driven pins.

A soft-model-to-target-system synchronization means is preferably provided in the ASIC emulator apparatus for causing the soft model to temporarily halt execution until it has received a predetermined number of input bits (i.e., the first digital data) from the pin dummy and/or for causing the target system to temporarily halt execution until it has received a predetermined number of output bits (i.e., the second digital data) from the soft model. This halting of execution allows the ASIC model and target system to operate in lock step with one another. The predetermined number of input and output bits exchanged between the target system and ASIC model during any one information-exchange cycle is preferably minimized such that only bits representing real/virtual pins which can change state during a specific operation are exchanged. Such minimization of the number of exchange bits can maximize the speed of information exchange between the target system and the soft model. This optimization of exchange speed helps to shorten target/ICUD transaction time (preferably to substantially less than about one millisecond per transaction) and thereby permits quick identification of "bugs" (design flaws) in the combined ASIC model/target system configuration under test.

The target system of the first embodiment, in combination with the pin dummy and the soft model projected therethrough, is preferably stepped through as many functional modes as reasonably possible, using various packages of commercially available software (i.e., application programs produced by third party vendors) executing on the target system, in order to expose the soft model to (hopefully) all possible interactions with the rich functional environment that the ASIC chip will ultimately face when the latter is fabricated and distributed to a diversified population of end-users. If the target system includes expansion slots/sockets for inserting expansion hardware produced by third party vendors, all reasonably-forseeable permutations of such expansion hardware should be inserted and operated with suitable application programs. Thus, the ASIC under development (which is still a "virtual" device that has not yet been fabricated as a prototype) is given the opportunity to interact with a rich spectrum of application software developed by parties other than the ASIC developer and a rich spectrum of complex hardware (including proprietary ASICS) developed by other vendors for use in the target system. Subtle incompatibilities between the virtual device (ICUD) and its target system (or systems) can be discovered and the reason for the existence of the incompatibilities can be determined and corrected before a prototype chip is fabricated.

The soft model of the ASIC device under development (ICUD), or soft model "portion" thereof, is preferably combined, in its software environment, with an embedded logic analyzer/test signal injector means which is suitably adapted for monitoring desired internal states of the soft model (portion), for collecting information about those states (data capture) upon the actuation of predetermined trigger conditions (qualifiers) and for injecting software test vectors (test patterns) into various nodes (i.e., interpackage and intrapackage virtual pins) of the soft model (or soft model portion). Using the combination of an embedded logic analyzer/signal injector means and the actual input signals from a target system, it becomes possible to expose the ASIC model to the actual working conditions of the ASIC's intended environment(s), and at the same time, it becomes possible to monitor any internal state of the ASIC model when such monitoring is desired.

It should be apparent from the above, that complete information about all interactions between the target system and the ICUD can be obtained while the ICUD is still in a software-described stage. If the target system is to include more than one ICUD, all such not-yet-developed IC's can be simultaneously modeled with one or more of the above described techniques and the simultaneous interactions of the IC models ("virtual" devices) with each other and with other (hardware and software) parts of the target system can be studied prior to conversion of their corresponding software-descriptions into prototype ASIC's ("real" devices).

In accordance with a second embodiment of the invention, configuration information representing a gate-level model (or other hardware implementatable model) of either part or of substantially the entirety of an ASIC device under development is projected into a hardware emulator comprising an array of programmable logic devices. Programmable logic devices, or PLD's for short, usually have configurable logic blocks (CLB's) whose logic function may be determined by software programming, configurable input/output blocks (IOB's) whose signal direction can be controlled by software programming and configurable interconnection means (i.e., software-controlled multiplexors) for software-controlled routing of signals between the configurable logic blocks (CLB's) and/or the input/output blocks (IOB's). Such PLD's can be controlled by software to create emulators which model in hardware (which emulate) desired gate-level portions or even the entirety of the ASIC under development.

Since every PLD IC (chip) is packaged individually, and since it is desirable to be able to monitor any internal node within an arbitrary PLD IC, a first portion, rather than the entirety of each PLD IC (packaged integratedcircuit) is preferably reserved for emulating a preselected portion of a gate model of the ASIC device under development (ICUD) while a second portion of each PLD IC is reserved for the formation of an embedded hardware logic analyzer/test signal injector means. The latter means should include a sufficient amount of hardware (i.e., access pins, IOB's, programmable logic blocks and interconnects) to allow it to be configured by suitable configuration software for monitoring logic states at any randomly-selected internal node of the hardware model portion emulated therein and/or for injecting test signals into such a randomly-addressable node.

The PLD formed hard model portion of the ASIC device under development may be coupled directly to the target system, using a pin dummy (or indirectly coupled thereto by means of the previously described virtual-pin-register to counterpart (real)-pin-register mirroring techniques). The combination of the hard model portion, soft model portion and target system may be operated under either a real-time or a pseudo-real-time basis so that the PLD implemented model portion can be exposed to the full working environment of the target system and the target system can be exposed to all operating states of the not-yet-fabricated prototype IC (PIC).

During development of the ASIC model, the embedded logic analyzer circuitry of the PLD array will be configured, by means of suitable software, to monitor randomly-addressed test points within the hardware model portion of the device under development (ICUD) and to trigger a data collection operation upon the occurrence of desired trigger conditions. Data produced at user-selected (randomly-addressed) test nodes of the PLD-implemented gate-model is transmitted to and stored in suitable memory means whenever one of a set of predetermined trigger conditions (qualifiers) is satisfied. The stored data is then accessed via, for example, a workstation that is linked by a communication network to the PLD implemented model, and the captured data is studied to determine whether the ASIC model is interacting in a desirable manner with its target system. The hard model portion of the ASIC model and/or the embedded logic analyzer circuitry coupled thereto can be revised by transmitting suitable reconfiguration information (from the workstation) to the PLD array when such revision is desired.

Portions ot the ICUD which are not sufficiently developed for modeling at the gate level can be simultaneously simulated by behavioral level software in a suitable computer platform (i.e., engineering workstation) and the operating characteristics of these software simulated portions can be combined with the PLD-implemented hard model portion by creating a mirror image relationship between the input/output states of "virtual" pins/nodes in the software simulated portions and "real" pins/nodes in the hardware emulated portions, as described before.

In accordance with a third embodiment of the invention, an array of parallel processors is used for simulating the behavior of selected portions or the entirety of the ICUD and input/output states are exchanged between "virtual" pins/nodes of the parallel-wise simulated ICUD and a target system through the "real" pins of a suitable pin dummy to thereby "emulate" the ICUD.

### BRIEF DESCRIPTION OF THE DRAWINGS

Figure 1 is a flow chart showing, side-by-side, two previous methods for developing an application specific integrated circuit (ASIC).
Figure 2A is a flow chart diagram showing an ASIC development process in accordance with the present invention.
Figure 2B is a schematic of an information exchange system for duplicating states at complementary input and output nodes of separate digital systems each having its own synchronizing clock.
Figure 2C is a timing diagram showing the relationships between the clock signals of the A, B and E blocks shown in Figure 2B.
Figure 2D shows how Figures 3 and 5 are assembled by combining their individual pages.
Figure 3 is a block diagram (three sequential pages) of a first ASIC design and development system in accordance with the present invention.
Figure 4A is a schematic diagram of a first ASIC emulator circuit.
Figure 4B is a schematic diagram of a second ASIC emulator circuit.
Figure 5 is a block diagram (four sequential pages) of a second ASIC design and development system in accordance with the present invention.
Figure 6A is a block diagram of an ASIC emulator comprising an array of PLD's in combination with an array of parallel processors.
Figure 6B is a diagram of data packets which may be shuttled through a serial link formed between a workstation and an ASIC emulator in accordance with the invention.
Figure 7 is a block diagram showing how the definition of an ASIC model can be fragmented among a plurality of workstations and recombined by means of a communications network.
Figure 8 is a block diagram showing a further application of the pin-register/node-register mirroring technique of the invention.

### DETAILED DESCRIPTION OF THE PREFERRED EMBODIMENTS

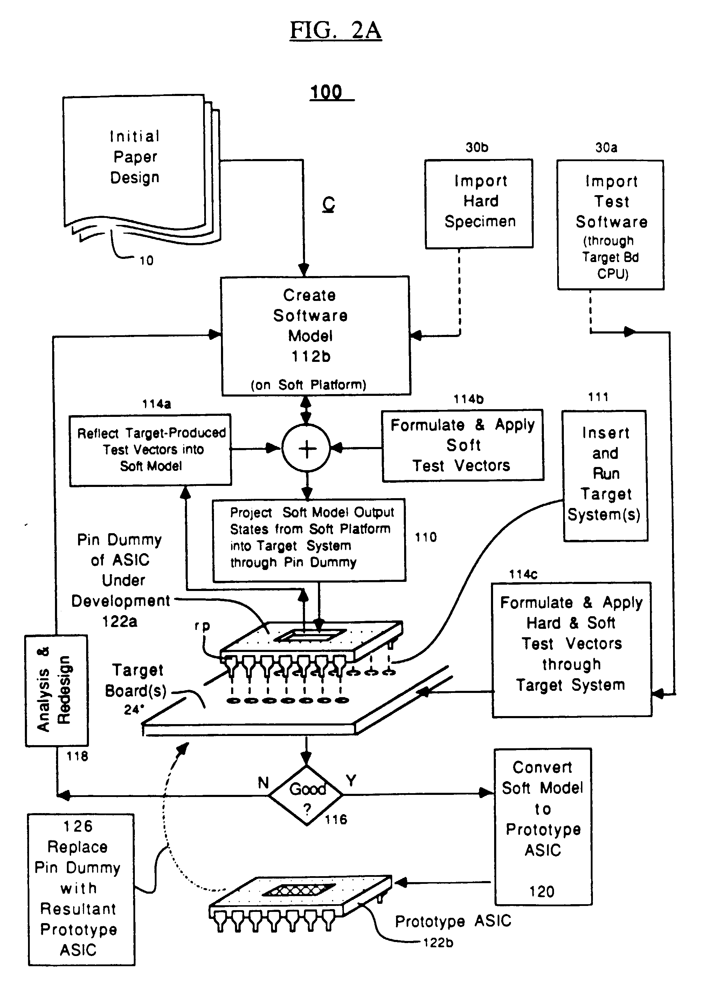

Referring to Figure 2A, there is shown a flow chart 100 of a method C for designing and developing an application specific integrated circuit (ASIC) prototype 122b in accordance with the present invention. According to this illustrated method C, an initial specification 10 of the functions to be performed by the not-yet-developed device (hereafter, "IC under development" or more simply ICUD) is provided and a software model 112b (soft model) is created to meet such specification 10 in a suitable software support platform such as a high performance workstation. The steps of formulating and applying soft test vectors 114b and of importing hardware specimens 30b into the software emulation environment may be performed as before, if desired. The step 30a of importing test software using an in-circuit CPU emulator can also be performed at the same time, as will be apparent shortly, simply by replacing a target system CPU with an in-circuit emulator.

Soft-model produced output signals (ASIC-responses), representing the logic states of "virtual" output pins (not shown) in the soft model 112b, are projected in synchronized fashion through the real pins (rp) of a pin dummy 122a into a target board 24* so as to replicate at "real" output pins of the pin dummy (target-driving pins), the logic states of the "virtual" output pins. The responses of the target board (target responses) to these soft-model-produced logic states are reflected back to the soft model in synchronous fashion through the real pins (rp) of the pin dummy 122a so as to replicate at "virtual" input pins (not shown) of the software simulated model 112b, the logic states of the "real" input pins (target-driven pins) on the pin dummy 122a. The software model 112b can be thereby exposed to the rich operating environment of the target board 24* and the target board can be simultaneously exposed to the operating states of the not-yet-fully-developed ICUD (which is emulated by the combination of the soft model 112b and the pin dummy 122a).

The functional correctness of the design of the ICUD (as defined by the soft model 112b) is tested (verified) by analyzing interactions between the emulated ASIC and its actual target system (or systems) 24* before a "real" (hard) integrated circuit prototype 122b (PIC) is fabricated at a soft-model to hardware-prototype conversion step 120. Analysis and redesign 118 of the soft model 112b occurs within a development loop whose inputs include the rich environment of an ASIC receiving socket in one or more target systems 24*. Target system "hardware" can be modified to represent multiple targets by inserting optional expansion hardware such as math coprocessors, graphics drivers, expansion boards, and so forth into the target system. The inputs of the development loop can further include the rich "software" environment of a multitude of third party application software packages that have been, or are being, developed for execution in the target system/systems.

Since the device under development (ICUD), as emulated by the combination of the pin dummy 122a and the soft model 112b, is exposed to the full operating conditions of one or more complex target systems 24* (i.e., hardware and software), it is fairly likely that design faults ("bugs") will be caught early during a software phase of the design/development process, rather than in an all-hardware phase, after the device under development (ICUD) is converted into a "silicon" prototype 122b (PIC). The time for design and development can be drastically reduced in comparison to previous methods.

The soft model 112b can initially be defined by so-called coarse-detail (coarse-grained), behavioral-level modeling techniques, and later, as development of the ICUD progresses, the soft model can be refined concomitantly with debugging so as to be expressed by so-called finer-detail (fine-grained), gate-level and transistor-level modeling techniques. By the time the development of the ASIC model reaches the finer-detail, transistor-level of description (or a like level of fine-detail description), the model should be free of so-called functional design bugs. Conversion (step 120) of the soft model 112b to a first run prototype 122b can then be carried out with substantial assurance that the prototype will be free of bugs.

When the prototype ASIC 122b is finally substituted in the target system 24* for the pin dummy 122a (step 126), the interactions of the "hard" prototype 122b with the target system should be substantially the same as those observed for the thusly developed, transistor-level soft model 112b. Accordingly, if the soft-model to ASIC conversion step 120 is flawless, the time-consuming step 120 of fabricating a prototype should not have to be carried out more than once. All functional bugs should have been eradicated prior to prototype fabrication. Development cost and time can be significantly reduced in comparison to that of previous methods.

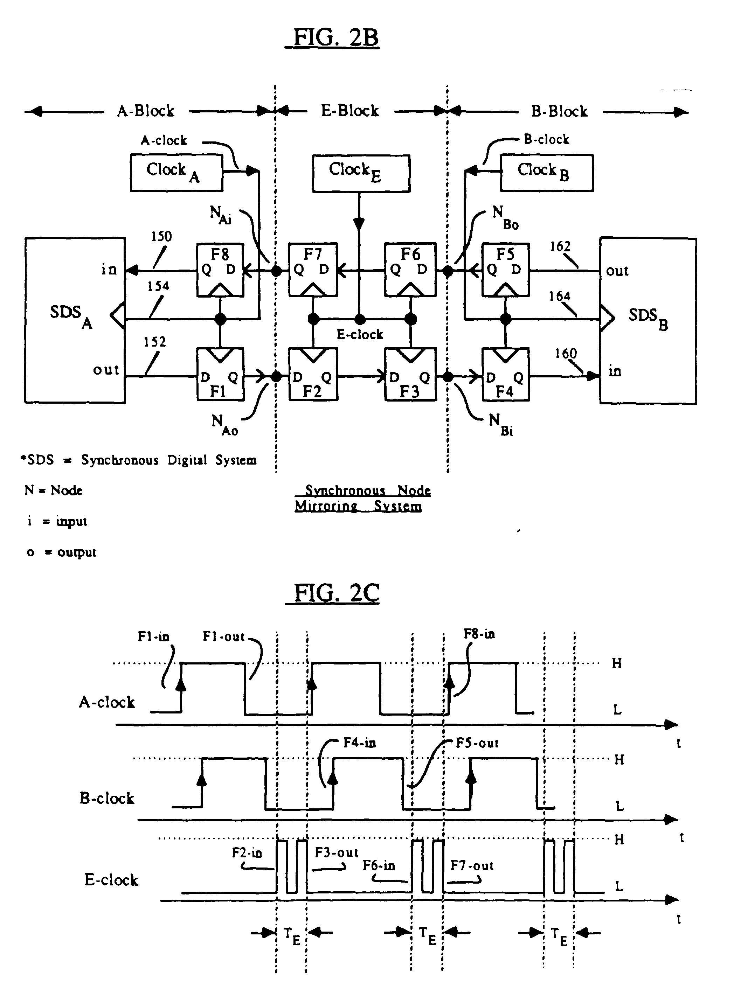

Referring to Figures 28 and 2C, a method will now be described by which mirroring can be realized between nodes of separately synchronized digital systems. Figure 2B shows a combined digital system having three different portions, a A-block, a E-block and a B-block, coupled to each other in the recited order and respectively synchronized by three different synchronizing clock units, Clock_{A}, Clock_{E} and Clock_{B}. The A-block comprises a first synchronous digital system SDS_{A} having an input terminal 150, an output terminal 152, and a clock receiving terminal 154. The output terminal 152 of first system SDS_{A} produces a digital output signal whose bits are loaded into an internal storage cell (latch, not shown) within a first flip-flop, F1, when the rising edges of clock pulses produced by clock unit Clock_{A} appear on a corresponding A-clock line. The pulses of the A-clock line are simultaneously coupled to the clock receiving terminal 154 of first system SDS^{A} and the clock receiving terminals of flip-flop F1 and another flip-flop, F8, provided in the A-block. Like flip-flop F1, the other flip-flop, F8, loads a binary level appearing at a D input terminal thereof into an internal memory cell (latch, not shown) on the occurrence of a rising edge on the A-clock line. Flip-flops F1 and F8 output the binary levels stored within their respective internal memory cells through respective Q output terminals on the occurrence of a falling pulse edge along the A-clock line. The Q output terminal of flip flop F8 is coupled to the input terminal 150 of first system SDS_{A} while the Q output terminal of flip-flop F1 is connected to an output node, N_{Ao}, of the A-block. The D input terminal of flip-flop F8 is correspondingly connected to an input node, N_{Ai}, of the A-block. Node N_{Ai} accordingly constitutes an input point of the A-block and node N_{Ao} constitutes an output point of the A-block.

The first synchronous digital system, SDS_{A}, may be made responsive to stimuli appearing at the input node N_{Ai} of the A-block, provided that such stimuli are presented when a rising edge simultaneously appears on the A-clock line. The response of first system SDS_{A} to such stimuli, which response appears as an output signal on output terminal 152, may be detected on the output node N_{Ao} of the A-block after a subsequent falling pulse edge of the A-clock. Logic levels which appear at input node N_{Ai} while the A-clock is low (before a rising edge) will not act as stimuli for the first system SDS_{A}. The stimulus/response (input/output) characteristics of the first system, SDS_{A}, may be studied by timely applying input signals at node N_{Ai} and detecting output signals at node N_{Ao}.

Referring to the B-block of Fig. 2B, it will be noted that this second block has a structure complementary to, and substantially the same as, the structure of the A-block. The B-block is synchronized by a B-clock line which couples the clock pulses of clock unit Clock_{B} to the clock receiving terminals of flip-flops, F4 and F5, as well as to the clock receiving terminal 164 of second synchronous digital system SDS_{B}. The Q output terminal of flip-flop F4 supplies stimulus signals to an input terminal 160 of second system SDS_{B}. The D input terminal of flip-flop F5 receives response signals from an output terminal 162 of second system SDS_{B}. Node N_{Bi}, which is coupled to the D input terminal of flip-flop F4, constitutes an input terminal to the B-block for supplying stimuli to the input terminal 160 of second system SDS_{B}. Node N_{Bo}, which is driven by the Q output terminal of flip-flop F5, constitutes an output node of the B-block, at which the response signals of output terminal 162 may be detected. The stimulus/response characteristics of the second system SDS_{B} may be studied by timely applying input signals to node N_{Bi} and detecting output signals at node N_{Bo}.

The E-block of Fig. 2B, which is interposed between the A-block and the B-block, constitutes a data exchange means for timely transferring information appearing at the output node N_{Ao} of the A-block to the input node N_{Bi} of the B-block and for timely transferring information appearing at the output node N_{Bo} of the B-block to the input node N_{Ai} of the A-block. Flip-flops F2, F3, F6 and F7 of the E-block respond to rising and falling edges of E-clock pulses output by the Clock_{E} unit in substantially the same manner as do the flip-flops of the A-block and B-block in response to their respective clock units, Clock_{A} and Clock_{B}. The Q output signal of flip-flop F1 is synchronously transferred through subsequent flip-flops, F2 and F3, to the D input terminal of flip-flop F4. The Q output signal of flip-flop F5 is synchronously transferred through subsequent flip-flops, F6 and F7, to the D input terminal of flip-flop F8.

Referring to the timing diagram of Fig. 2C, it can be seen that first and second systems, SDS_{A} and SDS_{B}, may be operated as if output node N_{Ao} were directly connected to input node N_{Bi} and further as if output node N_{Bo} were directly connected to input node N_{Ai} by appropriate control of the frequencies and phase relationships of clock signals A-clock, B-clock and E-clock. If the frequency of the E-clock is made sufficiently high relative to the frequencies of the A-clock and B-clock, so that two or more E-clock pulses appear in an information-exchange time period T_{E}, between a falling edge, F1-out, of an A-clock pulse and a subsequent rising edge, F4-in, of the next following B-clock pulse, a duplicate of the information appearing at output node N_{Ao} (at the time of falling edge F1-out) will appear at input node N_{Bi} (at the time of rising edge F4-in). It will appear to the first and second systems, SDS_{A} and SDS_{B}, as if nodes N_{Ao} and N_{Bi} were integral parts (fractions) of a hypothetical unitary node (not shown). Nodes which provide such timely duplication (mirroring) of information will be referred to herein as "node fractions" and it will be implied that complementary node fractions belong to a hypothetical single node. In the case where one node fraction is connected to a tangible (real) pin on an IC package and its complementary node fraction is an intangible (non-real) pin node being either simulated in software, or emulated in hardware, the first node fraction may be referred to as a "real pin" node while the second node fraction is referred to as its complementary "virtual pin" node.

Referring still to Fig. 2C, it can be similarly seen that if the E-clock has at least two pulses (denoted by leading edge F6-in and trailing edge F7-out) in the next exchange period T_{E} between falling edge F5-out of the B-clock and rising edge F8-in of the A-clock, a duplicate of the binary state appearing at output node N_{Bo} (at the time of falling edge F5-out) will appear at input node N_{Ai} (at the time of rising edge F8-in) so that nodes N_{Bo} and N_{Ai} appear to be node fractions of a second hypothetical unitary node (not shown).

The A-clock and B-clock are preferably operated at approximately the same frequency in order to realize such a node mirroring function. An arbitrary phase relation may be established between the A-clock and B-clock signals, but of course, a zero phase relationship is preferred and a 180° phase relationship should be avoided. A data exchange window of determinable duration T_{E} should be defined between a falling edge of the A-clock and a subsequently rising edge of the B-clock (and vice versa). The E-clock frequency should be sufficiently high to enable full information exchange within the exchange window T_{E} so as to establish equivalent logic levels at corresponding node fractions. For the sake of clarity, only two pulses are shown in each data exchange window T_{E} of Fig. 2C. It should be apparent that the waveform of the E-clock can comprise many more pulses than just the pairs shown in each data exchange window T_{E}. Also it should be apparent that the number of E-clock pulses in each exchange window T_{E} is directly related to the number of data shifting stages (F2 and F7 define such a stage) in the E-block information exchange section so that more E-clock pulses are required in each exchange window T_{E} if the number of shifting stages is increased in the E-block.

Since equivalent logic levels appear at corresponding input/output nodes, N_{Ai}/N_{Bo} and N_{Bi}/N_{Ao}, the nodes of each pair may be considered mirror counterparts of one another. From the internal perspective of the first and second digital systems, SDS_{A} and SDS_{B}, it appears as if each mirror-related pair, N_{Ai}/N_{Bo} for example, constitutes a hypothetical unitary node (not shown).

While this alone may not appear to be advantageous, the mirror relationship within each of node pairs, N_{Ao}/N_{Bi} and N_{Bo}/N_{Ai}, becomes extremely advantageous for the purpose of debugging the combination of the A-block and the B-block, particularly when the A-block and B-block are spaced apart from one another such that it becomes impractical to run a common clock line (the A-clock or the B-clock line) between the two blocks (A and B). The mirror relationship within each of node pairs, N_{Ao}/N_{Bi} and N_{Bo}/N_{Ai}, becomes even more advantageous when one or both of the first and second digital systems, SDS_{A} and SDS_{B}, is being simulated in software, or emulated by an array of software-programmable logic arrays, rather than being implemented each in final form as an integrated circuit defined on a monolithic semiconductor substrate, a printed circuit board, or the like.

By way of illustrating the advantages of such information exchange, let it be assumed that the first digital system SDS_{A} is being simulated entirely in software and that the binary state of simulated output terminal 152 is stored (supported) within the internal memory cell (not shown) of flip-flop F1 while the binary logic state of input terminal 150 is similarly stored in the internal memory cell (not shown) of flip-flop F8. Let it be further assumed that the second digital system SDS_{B} is implemented in hardware (either in a final design form or in an emulated form supported by emulation hardware). As long as the software simulated version of the first system SDS_{A} is fast enough to keep pace with the A-clock, it will be transparent from the viewpoint of the second system, SDS_{B}, whether the first system, SDS_{A}, is being being implemented in hardware or software. Similarly, it will be transparent from the point of view of the first system SDS_{A} whether the second system SDS_{B} is implemented in software or hardware. Accordingly, the first and second systems, SDS_{A} and SDS_{B}, may be developed independently of one another, at separate locations if necessary, with each digital system being implemented either in software or hardware, as desired and their combined interaction can be studied by using a data exchange means such as the E-block of Fig. 2B. Such an arrangement provides system developers with great flexibility.

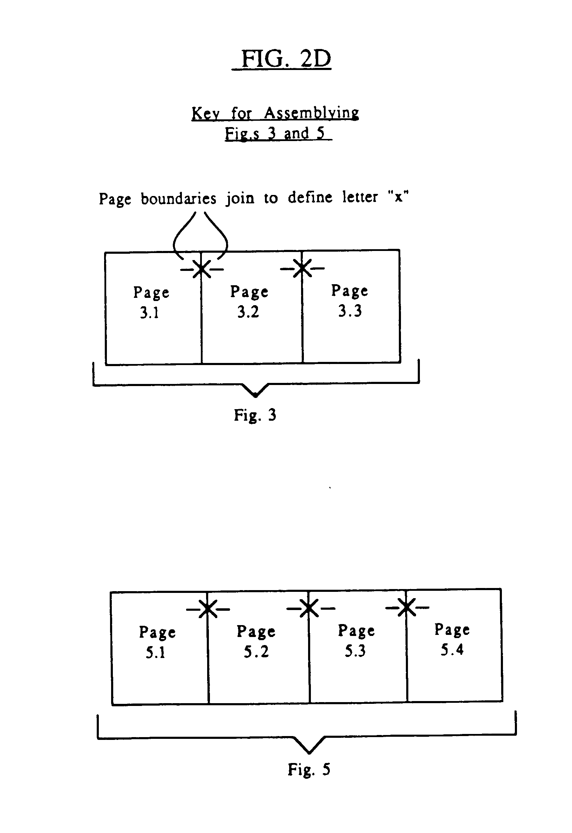

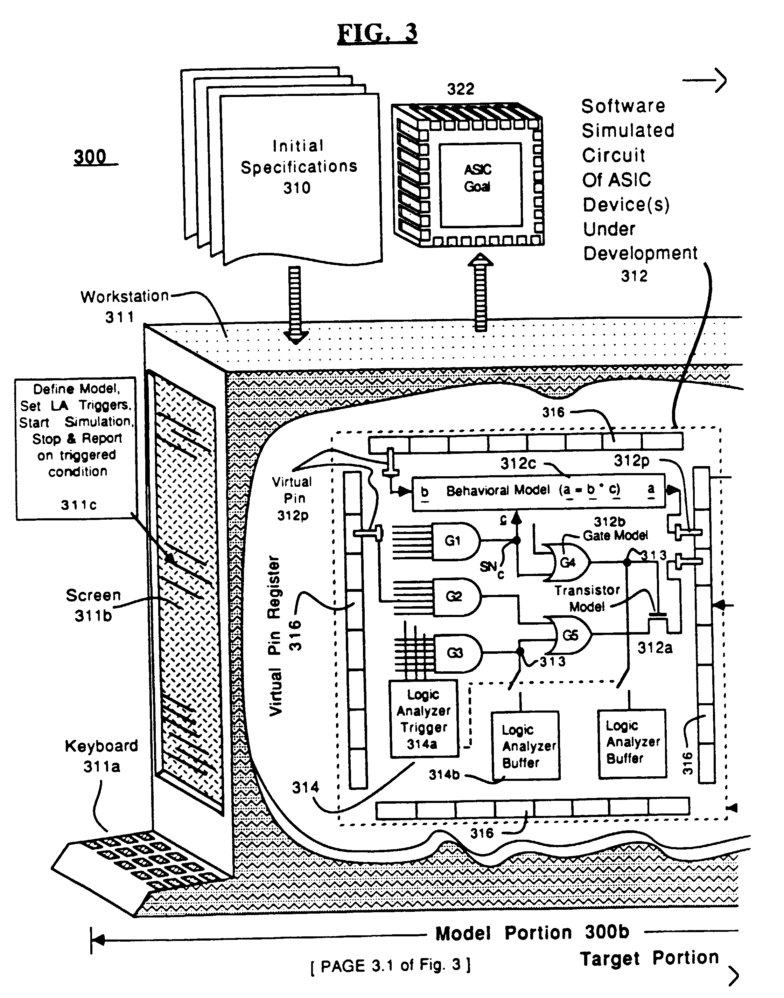

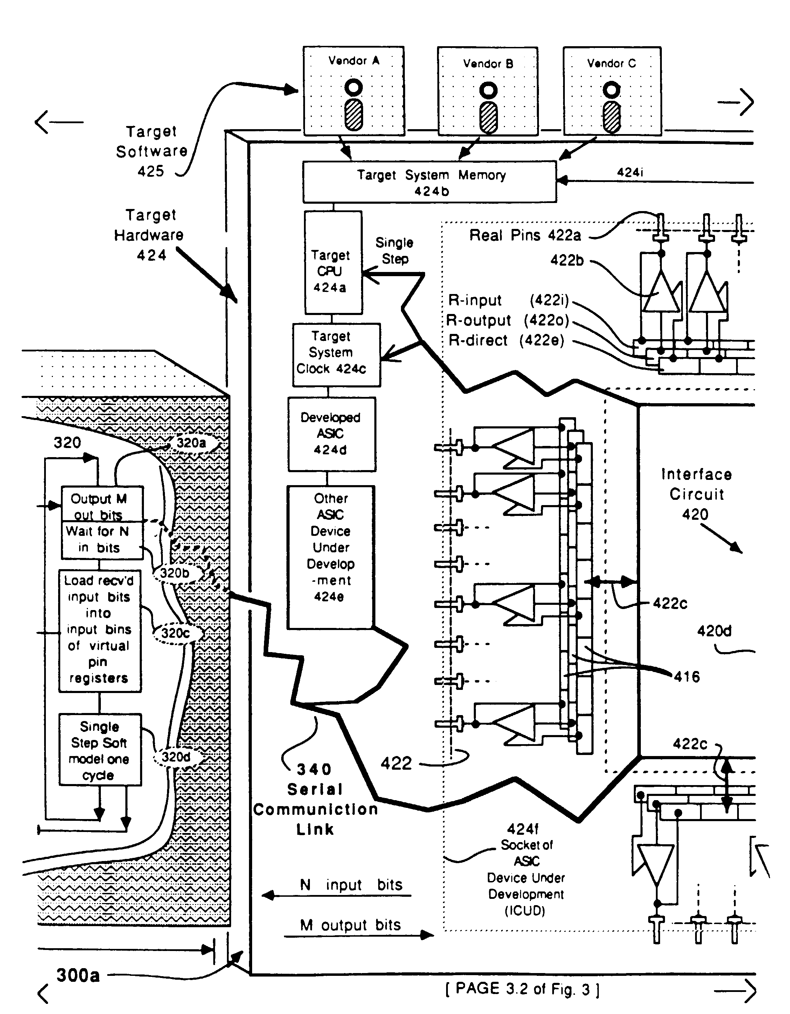

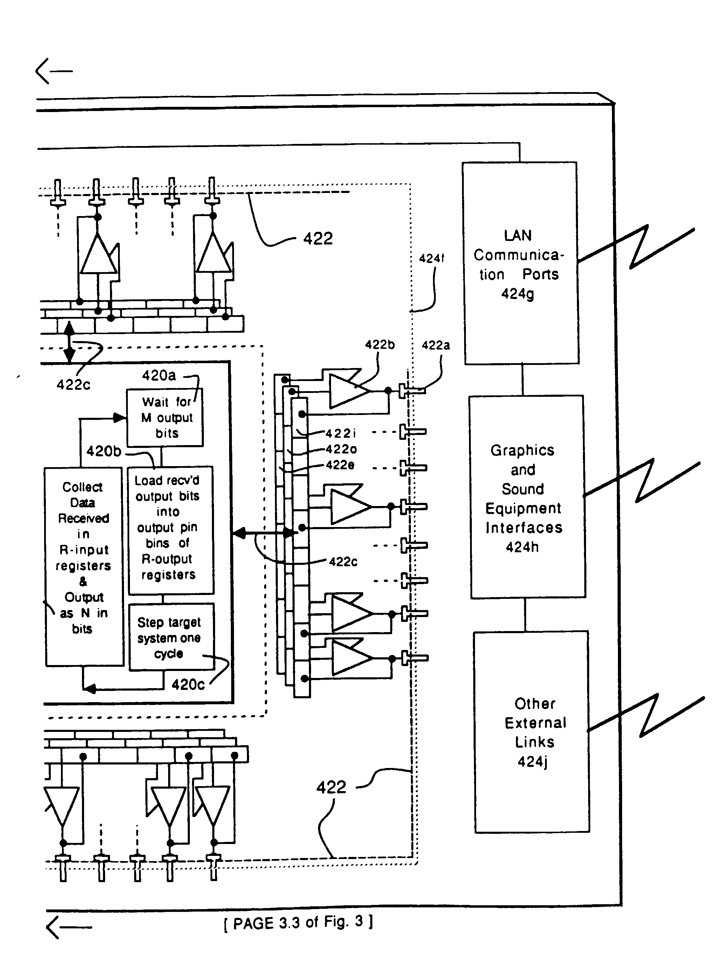

The principles and advantages of the invention can be more fully appreciated by referring to a specific example such as the one illustrated by the block diagram of Figure 3, wherein a first embodiment 300 of the invention is shown. Fig. 2D illustrates the manner in which pages 3.1, 3.2 and 3.3 of Fig. 3 are to be combined. Broadly speaking, Figure 3 shows a design/development system 300 comprising a "Target Portion" 300a into which a not-yet-developed ASIC is to be incorporated and a "Model-supporting Portion" 300b into which a software description of the ASIC design is to be loaded. A virtual-pin to real-pin mirroring technique is applied to create tight coupling between the ASIC software model and the target hardware into which the final ASIC chip is to be inserted.

Design/development of the ASIC begins with the creation of an initial set of specifications 310 describing the yet-to-be-fabricated ASIC (which specifications could be in the form of computer readable, coarse or fine detail, design criteria). The design/development of the ASIC proceeds (as will be described shortly) until all "bugs" that can be reasonably identified within the tightly coupled ICUD/target environment of the invention are so identified and eradicated. A substantially "bug-free" prototype ASIC 322 is then produced (denoted in Figure 3 as an "ASIC Goal") by automatically converting the software description of the ASIC into an integrated-circuit embodiment.

Referring first to the "Model Portion" 300b of Figure 3, an initial software model 312 (soft model) of the device under development (ICUD) is devised and programmed into a suitable platform such as an engineering workstation 311. The workstation 311, by way of example, can be a high performance development system such as the Sun-4™ workstation available from Sun Microsystems of Mountain View, California or a similar system provided by Hewlett-Packard of Palo Alto, California. The soft model 312 may be defined with one or more simulation software packages that can include so-called computer aided engineering (CAE) and computer aided design (CAD) packages such as MDE-LDS™ available from LSI Logic Corp. of Milpitas, California or similar design-simulation packages available from Mentor Graphics of Beaverton, Oregon, or Cadence (Intergraphics) of California, or other such software vendors. Preferably, the instructions per second (IPS) execution rate of the workstation 311 should be on the order of one million instructions per second (MIPS) or higher and the number of computer instructions executed for each soft model "clock" cycle should be sufficiently small so as to enable the soft model to operate at a real-time speed of one thousand ASIC clock cycles per second or higher.

The software model 312 itself can be formed to define the ASIC under development in coarse and/or fine-grained terms as desired. As an example of what is meant by coarse and/or fine-grained terms, the soft model 312 can include any or all of a transistor-level model portion 312a, a gate level model portion 312b and a behavioral-level model portion 312c, each corresponding to one of the various portions of the device under development (ICUD). Of course, the entirety of the ICUD can be defined at a single level of detail if so desired. Those skilled in the art will appreciate that the term "transistor-level model" refers to a relatively detailed (fine grained) description of the final device wherein basic components such as transistors, resistors, etc., are each individually defined. The term "gate-level model" refers to a higher level of circuit description (intermediately grained) wherein the Boolean operation of various logic components such as AND, OR, NOT, etc., gates are described but their internal transistors are not. The term "behavioral-level model" refers to an even higher level of description (coarse-grained) wherein the logic/gate architecture of the device (ICUD) is not defined, but rather, the overall input/output behavior of the modeled portion is described by way of suitable software.

In terms of a further example of what is meant by coarse and fine grained models, let it be assumed that the final device (goal device) 322 is to include a complex arrangement of gates implementing a digital function of the form a = f(b,c,d,e,...), where the operation to be performed could be a 64 bit multiply or a convolution operation or a three dimensional image rotation or some other complex function. The behavioral level model 312c of this complex function would describe the input and output characteristics of the function without having to actually describe fine-detail attributes such as the bit width (word size) and bit format (data structure) that is to be ultimately used in implementing the digital function a = f(b,c,d,e,...). The internal logic gate configuration of the circuit that is to be used to realize this function, or the transistor level configuration of that circuit would also not have to be specified at the behavioral level. The gate-level description would, on the other hand, usually define exactly how many bits are to be provided in each data word, the specific placement of the bits within each data word, the specific types (i.e., AND, OR, NOT, Flip-Flop, etc.) of logic components (gates) to be used and the specific interconnections between input/output terminals of the latter. The gate-level description would not, however, define in detail the type or number of transistors that are to be used to implement basic Boolean functions. In contrast, the transistor level description would usually define specifically what type of field-effect, bipolar, or other transistor is to be used in forming the logic circuitry of the prototype IC (PIC), the number of such transistors, and perhaps their specific placement on the chip substrate and the conductor patterns to be used for their interconnection on the PIC. (The next level below the transistor-level would be the diffusion level which describes the geometries of specific regions in each semiconductor device and the specific layout of conductor patterns.)

All three levels of model description (312a, 312b, 312c) are schematically illustrated in Fig. 3 as existing within the software environment of the workstation 311. For the sake of brevity, behavioral model portion 312c is shown as implementing a two-input-parameter/one-output-parameter function, a = b * c where the bit widths of the input/output parameters a, b and c are equal to unity. It should be noted that more complex behavioral models having multiple input/output parameters each of a bit width much greater than unity are, of course, well within the contemplation of the invention.

It will be noted that Fig. 3 shows the behavioral model portion 312c to have one of its input parameters, b, supplied by a first "virtual" pin 312p and another of its input parameters, c, supplied from a "soft node", SN_{c}. The latter, node SN_{c} defines the intersection of the output line of AND gate G1 and input line of OR gate G4 with the parameter input line c of the behavioral model portion 312c. Output parameter, a, of the behavioral portion is shown coupled to a second virtual pin 312p. The output line of OR gate G4 is shown driving an FET gate electrode that is defined within the transistor-level model portion 312a. The output line of OR gate G5 is shown driving an FET source electrode. The drain electrode of the FET is coupled to a third virtual pin 312p. AND gate G2 is shown to have one input line connected to a fourth virtual pin 312p.

It should be understood that the specific interconnections between the model portions are shown merely for the sake of illustration. The overall soft model 312 can be defined to include an arbitrary number of behavioral, gate or transistor level model portions, as desired, depending on the memory capacity of the workstation 311. It will be understood that these model portions can be interconnected to one another by input/output buses of arbitrary bit widths; that individual bus lines can be coupled to one another by any of an arbitrary set of "soft nodes" (i.e., SN_{c}); and further that these model portions can also be coupled to an arbitrary set of "virtual pins" 312p, as desired.

It should further be appreciated that the soft model 312 is not limited to just the above recited levels of fine/coarse descriptive detail (behavioral, gate and transistor levels) but rather that these terms identify relative points along a continuum of finely or coarsely detailed modeling techniques. The continuum can be characterized as extending from a coarse-grained (nondetailed) description of various components (i.e. macrocells) in the end product (goal ASIC 322) to a fine-grained, detailed (i.e., diffusion-level) description of the same. All modeling techniques along such a continuum are within the contemplation of the invention.

When it is first drafted, the specification 310 for the to-be-developed ASIC will often contain "crudely" drawn (broad-brush) design portions whose finer details (fine-grained features) are intended to be filled in at a later time (i.e., during later design/development). Initially these crude portions are described in the soft model 312 at a coarse-grained (i.e., behavioral) level and then as time goes on, the description is made more finely detailed, until eventually, the description is sufficiently detailed to enable automated transformation of the soft model 312 into a prototype ASIC 322. It is one aspect of the invention that the tight ASIC/target coupling method can be practiced throughout the design/development process, from the point where the ASIC description is first crudely-drawn to the point where the ASIC description is finely-detailed.

If at the front end of the design/development process, when the ASIC description is crudely-drawn, coarse incompatibilities exist between the target system and the coarsely defined soft-model 312, these incompatibilities can be exposed and perhaps eradicated at such a front end of the design/development process by projecting a "hard" image of the coarse model through a pin dummy into the hardware of the target system and by reciprocally projecting a "soft" image of the target system through the same pin dummy into the software environment of the soft model so as to induce tightly-coupled interactions between the target system and the coarse model. Basic errors (i.e., incorrect design assumptions) can be found and corrected before time and effort is expended (perhaps in a wasteful manner) to define crudely-drawn components of the initial ASIC model in a more finely detailed way. Development time should be drastically reduced by identifying basic incompatibilities at the outset of design/development.

This is a key advantage of the present invention. Because tight coupling between the target system and model is made possible at the outset of design/development, crude interactions between the respective "virtual" pins and "real" pins of an ASIC model and target system hardware can be studied immediately. This allows immediate identification of major oversights by design engineers and thereby prevents misdirected development efforts.

This aspect of the invention can be further explained as follows. In many situations, the goal ASIC 322 is required to cooperate with a software-application package that has been created (or is being simultaneously created) by a third-party, but conditions are such that the developers of the ASIC do not possess full knowledge of the third-party software. For the purpose of example, let it be assumed that the third-party software-application package in question performs a multitude of three-dimensional graphics-processing functions, all of which must interrelate one with the other, and further, that the ASIC in question is to be designed to perform a high speed image rotation function in place of a slower image rotation function provided within the software package.

If the designers/developers of the ASIC initially plan to perform such rotation in Cartesian (x, y, z) coordinates without for some reason knowing that the software package operates in spherical coordinates (r, θ, φ), extreme incompatibility could result. Attempting to join such a Cartesian-based ASIC design with a spherical-based software package could be seen as being akin to the classic problem of trying to force a square peg into a round hole. It would be highly undesirable to have a design/development process wherein such a fundamental incompatibility is not discovered until after a prototype ASIC is manufactured.

With the present invention, however, such an incompatibility can be identified at the front-end of product development, while the ASIC model is perhaps only coarsely described by one or more behavioral-level model portions, rather than at the tail-end of development, when extensive development effort has already been expended, the prototype ASIC has been finally installed into a target system and the graphics software package is then, for the first time, exercised in tightly-coupled combination with the ASIC.

Of course, those skilled in the art will appreciate that the above example is a highly exaggerated hypothesis of how target/ASIC design incompatibilities may develop in commercial practice. Few developers would attempt to design a chip without knowing at least something about coarse aspects of the functions to be performed in the target system. But the ASIC/target incompatibility problem can surface in more subtle ways. Hard-to-see mismatches often exist in commercial practice between, for example, message handshaking protocols adopted by a group of ASIC developers at their side of an integrated product development process and slightly different messaging protocols adopted by a group of software package developers at their side of either a joint or ASIC-after-software development process.

With the present invention, such incompatibilities between hardware and application software can be flagged at the outset. Side-by-side (joint) development of an ASIC and an application-software package could begin even when the ASIC model and the corresponding software package are both at relatively early stages of their respective development cycles. Early discovery of hard-to-see mismatches is made possible by projecting both a hard image of the virtual ASIC and the object code of the software package (target software 425) into a common target system and observing their tightly-coupled interactions.

The software model 312 of Fig. 3 (which can be described here as a "virtual" ASIC), is preferably combined, in its simulation environment, with an embedded (software-created) logic analyzer/test signal injector means 314 for monitoring internal nodes ("virtual" test points) 313 of the software model 312 and for injecting software generated test signals into that model at the same or other, preselected virtual test points 313. The embedded logic analyzer/test signal injecting means 314 can include trigger means 314a for specifying internal conditions (qualifiers) upon which a data collection activity (data capture) is to take place and it can include one or more data collecting buffers 314b for collecting such data from the desired test points 313 and storing the collected data for analysis.

Preferably, the workstation 311 is provided with user-interactive input/output means such as a keyboard 311a and display screen 311b for interactively defining the soft model 312, setting qualifier conditions for the embedded logic analyzer 314, starting a simulation run and analyzing report data produced by the logic analyzer 314 (as indicated in Figure 3 by the sample screen insert, 311c).

The workstation 311 is provided with a virtual-pin register means 316 (or other suitable memory means) for storing digital information representing the states of various input and output pins (virtual pins) 312p of the not-yet-fabricated goal device (PIC) 322.

For the purpose of example, it will be assumed that the goal device (PIC 322) has a predesignated number, P = N + M, of active pins whose logic states can change during a specific operating mode, where N of these pins function as input terminals during the specific operating mode and M of these pins function as output pins during the same operating mode. The corresponding virtual-pin register means 316 in the workstation 311 is preferably provided with sufficient memory capacity for storing the logic states of the N input pins and the M output pins (virtual pins) of the not-yet-fabricated goal device 322 for each simulated machine cycle. Although the soft model does not have "real" pins as will the ASIC prototype, those skilled in the art will appreciate that the soft model can be defined (designed) to have "virtual" pins 312p which simulate in software the hardware action of the real pins, that action including the exchange of information between the interior and exterior of an ASIC chip package. Predetermined memory cells within the workstation 311 can store information representing the simulated states of the real pins. Such memory cells correspond to the information storing cells of the flip-flops, F1 and F8, shown in Fig. 2B.

A first interface means 320 is provided in (or coupled to) the workstation 311 for stepping (function 320d) the soft model 312 through a predetermined number (usually one) of simulated machine cycles and for temporarily halting (function 320b) the soft model 312 at the end of the predetermined number of cycles to await receipt of N input bits (target-produced bits) from a soon-to-be described second interface means 420 on a target system 424. The first interface means 320 loads (function 320c) the received N input bits into appropriate bins (state storing cells) of the virtual-pin register means 316 and then steps (function 320d) the soft model 312 through a corresponding number of machine cycles (i.e., usually one simulated clock cycle) to thereby produce an ASIC-response to the N-input bits. The resultant (responsive) output pin states of the soft model 312 are stored as bits in output bins of the virtual-pin register means 316 and these output states are transmitted (step 320a) to target system hardware 424 (in the "Target Portion" 300a of the development system 300) through the complementary, second interface means 420, whereafter they are replicated in a complementary (mirroring), real-pin register means 416. (The real-pin register means 416, which will be described shortly, is illustrated in Figure 3 as being comprised of respective input, output and direction enabling registers, 422i, 422o and 422e.) "Real" output bits, which are mirror copies of "virtual" output bits in the ASIC model 312, are then synchronously presented to the target system hardware 424 through the real pins 422a of a suitable pin dummy 422.

The pin dummy 422 comprises at least the real pins 422a but can further be designed to integrally incorporate, if desired, any or all of tristate drivers (buffers) 422b, input register 422i, output register 422o, direction enabling register 422e, bit-exchange bus 422c, and the second interface means 420; coupled one to the next as shown, with all or some of the latter recited components being integrally formed on an integrated circuit substrate (not shown) that is housed in a package frame supporting the real pins 422a of the pin dummy 422.

While the text above designates the function of certain pins as being either "input" or "output", it should be understood that this functionality can be dynamically changed so that any desired pin may support bidirectional signal flow. Bidirectional signal flow may be realized for example, by altering the bits in the direction control register 422(e) (R-direct) at suitable points in time. Bidirectionality in the corresponding virtual pins of the soft model 312 may be realized with well-known programming techniques.

Many methods will occur to those skilled in the art for implementing the first interface means 320 once its operation is understood. In one method of so doing, no new software has to be added to the circuit simulation programs (CAD/CAE) of the workstation 311. Instead, the first interface means 320 is simulated in the workstation 311 as a circuit having a suitable sequential state machine for counting N input bits, loading N input bits (received from a serial communications package of the workstation) into appropriate bins of the virtual-pin register means 316, single stepping the soft model 312 (using a "software-simulated" clock line of the soft model 312 or other suitable single stepping means provided within the soft model 312), and awaiting the development of a "response" by the soft model. The M output bits produced by the soft model 312 are collected by the first interface means 320 and serially transmitted over a standard communication link 340 (i.e., RS-232, SCSI, Ethernet, Ultranet, etc.) to the second interface means 420.

It is, of course, possible to develop a special software program combined with a special hardware add-in board for implementing the described functions of the first interface means 320 either by inserting such special software and/or hardware directly within the workstation 311 or by installing such within an add-on, network communication module of the workstation 311. For most cases, the above technique of implementing the first interface means 320 by software is the most cost effective.

The thus far described combination of the workstation 311, soft model 312 and first interface means 320 has been referred to as the "Model Portion" 300b of the design/development system 300. As mentioned earlier, a "Target Portion" 300a is also included in the overall design/development system 300. This Target Portion 300a is preferably provided adjacent to and coupled to the Model Portion 300b as shown in Fig. 3 but it can also be located far away from the workstation and linked to the workstation through a local area network (LAN) or even through a long-lines telecommunication network if so desired.

The Target Portion 300a comprises target hardware 424, which by way of example could be a printed circuit mother-board of an expandable micro-computer system, and application software 425 (either pre-developed or concurrently being developed with the ICUD) which software 425 (represented in Fig. 3 by floppy disks) is to be executed in the target hardware 424.

The target hardware 424 will usually include a central processing unit (target CPU) 424a; a memory means 424b coupled to the target CPU 424a and/or coupled to other parts of the target hardware for supplying software instructions to various portions of the target hardware 424 and for storing target system data; and a system clock means 424c for synchronizing data transfer between the CPU 424a, memory means 424b and other parts 424d-424j of the target hardware 424. The other parts 424d-424j could include one or more already-developed ASIC's 424d, one or more other ASIC's under development (ICUD's) 424e, chip sockets 424f for receiving the pins of prototype ASIC's after such chips are fabricated, local area network (LAN) ports 424g for interfacing with external systems, graphics and sound equipment interfaces 424h, and other external links 424j such as expansion board slots for coupling to expansion hardware and software. It can be understood from this, that when the pin dummy 422 is plugged into the receiving socket 424f of an ASIC-under-development, a complex set of logical interactions (i.e., millions of nondeterministic bits/bytes being exchanged in a short period of time) can take place between the ASIC model (i.e., such as the virtual device defined by soft model 312) and the target system (hardware 424, software 425 and expansion-added portions thereof (not shown)).

The complementary interface means 420 of the Target Portion 300a is suitably configured to bidirectionally communicate with the first interface means 320, preferably over a serial communication link 340 such as RS-232, SCSI, etc., so as to load appropriate bins of the real-pin register means 416 with the M output-pin bits (ASIC-produced bits) supplied to it through the link 340, and to transmit back through the link 340 to the soft model 312, a new set of N input-pin bits which have just been received from the target hardware 424, the new set of N input bits being one comprising bits that have been transmitted through pins of the pin dummy 422 and stored in corresponding input bins of the real-pin register means 416.

As shown in Fig. 3, the real-pin register means 416 may be comprised of an input register R-input (422i), an output register R-output (422o) and a direction enabling register R-direct (422e). Output terminals of the direction enabling register 422e are each coupled to a tristate output enabling terminal of a corresponding driver among tristate drivers 422b. Output terminals of the output register 422o are each respectively coupled to a corresponding input terminal of one of the tristate drivers 422b. Output terminals of the tristate drivers 422b are each coupled to a corresponding one or more of a set of real pins 422a provided in the pin dummy (probe head) 422. The latter, 422, is ot course suitably configured for mating with a target socket 424f into which the yet-to-be developed ASIC 322 will be ultimately inserted. The real pins 422a of the pin dummy 422 are each further coupled to a corresponding input terminal of the input register 422i.

As explained earlier, any or all of the tristate drivers 422b, input registers 422i, output registers 422o, direction registers 422e and the complementary interface means 420 can be integrally incorporated in a package frame (not shown) of the pin dummy 422 along with the real pins 422a. A serial transmission cable (serial communication link 340) extends between the complementary interface means 420 and the work station 311 for serially exchanging data between the latter two units.

The complementary interface means 420 is preferably provided with a target system synchronization means 420a-420d which, as indicated in Fig. 3, awaits the reception of M output bits (function 420a) from the workstation, loads the received M output bits (soft-model-produced target-stimuli) into corresponding output bins of the output registers 422o (function 420b), steps the target system by a predetermined number (usually one) of target system cycles (function 420c), extracts the responsive N input bits (target response) received by the pin dummy 422 from the target system 424 (function 420d) and then loops back to function 420a to await the next set of M output bits (ASIC response) from the soft model 312.

The direction enabling register 422e is preferably loaded only once, during a pin-dummy initialization step, and thereafter only the predesignated P = M + N active bits of a specific operational mode are exchanged along the serial communication link 340. This limitation of the number of exchanged bits to only the predesignated minimum value, P, helps to minimize the delay attributed to the exchange of information between the real and virtual pin registers thereby allowing the combination of the soft model 312 and the target system (424, 425) to quickly cycle through their transactive states. The number P is preferably selected such that transaction cycle periods will be much less than one millisecond and more preferably, less than one microsecond.

Those skilled in the art will, of course, appreciate that the above is but one way of synchronizing information exchange between the soft model 312 and the target system 424, 425. If desired, either or both of the respective ASIC-stimuli awaiting and target-stimuli awaiting functions, 320b and 420a, can be eliminated and the clock frequencies of the soft model 312 and/or the target system can be appropriately slowed or sped up to synchronize data exchange between the two if such speed change is deemed necessary.

In some cases, the goal ASIC 322 will include one or more target-system-to-ASIC handshake control pins for automatically synchronizing data exchange between the ASIC and the target system. The software-simulated handshake functions of these pins can be used in place of functions 320d and/or 420c to synchronize information exchange between the virtual pin register means 316 and the real pin register means 416. In some circumstances, it may be possible to include synchronizing pins on the ICUD and its prototype (i.e., to daisy chain the target system clock line through a plurality of ICUD's) even though the production ASIC's will not have these synchronizing pins. In other cases, the workstation 311 may be configured to operate at sufficient high speed so that the soft model 312 can easily outpace the clock of the target hardware 424 and a "clock" receiving pin (virtual) of the ASIC model can provide synchronization. The target hardware 424 can, in such latter cases, be allowed to run at its full speed (its natural speed) and no special synchronizing circuit (i.e. function 420c) needs to added to the target hardware 424 for enabling synchronous exchange of data between the virtual pins 312p of the soft model 312 and the real socket 424f of the target system.

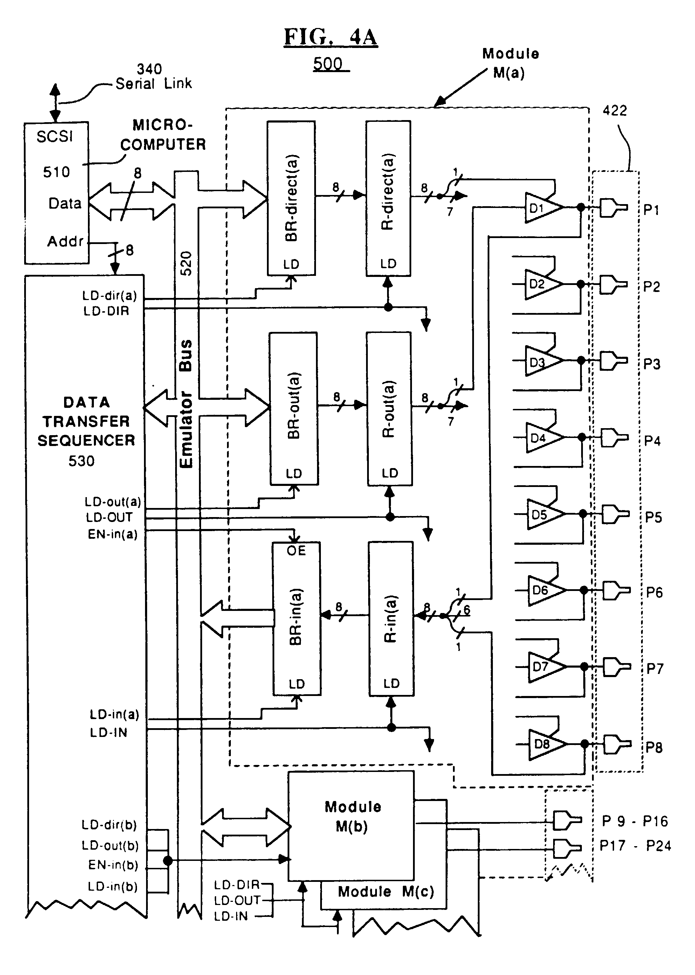

In Fig. 4A, there is shown a first ASIC emulator circuit 500 which may be used in conjunction with the invention. The ASIC emulator circuit 500 preferably comprises a microcomputer 510 having a suitable serial and/or parallel interface port (i.e., an RS-232 port or so-called "small computer standard interface (SCSI) port that is recognized in the industry as a standard interfacing means) coupled to the serial communication link 340, an eight bit wide data port (Data) coupled to an eight bit wide emulator bus 520, an eight bit wide address port (Addr) coupled to a data transfer sequencer 530 and a suitably programmed memory (not shown) for coordinating data exchange between the real pins of the pin dummy 422 and the virtual pins of the soft model 312.

The emulator bus 520 operates as a common pathway for exchanging information in a time multiplexed fashion between the microcomputer 510 and a plurality of pin modules, M(a), M(b), M(c), . . ., etc. Each pin module M(x) comprises: a direction buffer register, BR-direct(x); an output buffer register BR-out; an input buffer register BR-in(x), and coupled respectively to these buffer registers, a primary direction register R-direct(x), a primary output register R-out(x) and a primary input register R-in(x); the symbol "x" denoting here a specific module, M(x). "Real" pin data is stored parallel-wise in the memory cells of each of the primary input/output registers, R-in(x) and R-out(x). The direction registers R-direct(x) have output lines connected to the "output-enable" terminals of tristate drivers D1-D8 as shown for programmably enabling the transmission of output bits stored in the output registers, R-out(x), to desired ones of the real pins P1-P8, P9-P16, etc., of each module M(x). The buffer registers, BR-direct(x), BR-out(x) and BR-in(x), function as temporary storage means for enabling time multiplexed data exchange (serial data exchange) over the emulator bus 520. The bits stored in primary registers, R-direct(x), R-out(x) and R-in(x), are of a more parallel nature in that they may be simultaneously transmitted (parallel-wise) between the primary registers and their corresponding buffer registers or real pins as will be explained now in more detail.

The microcomputer 510 converts serial data (i.e., virtual pin register data) received along the serial link 340 from the work station 311 into eight bit wide packets of parallel data and transmits packets containing output-bit portions of the received workstation data along the emulator bus 520 to the output buffer registers BR-out(x) of each individual module M(x) in time multiplexed fashion (one module M(x) is loaded at a time). Data transfer sequencer 530 is activated by the microcomputer (i.e., through the address port, Addr) to sequentially issue module specific strobe signals LD-out(x) to each of the modules M(x) to cause the respective output buffer registers BR-out(x) of the strobed modules to be loaded with data present on the emulator bus 520. After the serially-received data is thus routed and loaded into the output buffer registers of all active modules M(a), M(b), M(c), . . ., M(x) the data transfer sequencer 530 issues a global output-strobe signal LD-OUT simultaneously to all the primary output registers R-out(x) of the modules, M(a) through M(x), thereby to cause those parallel-wise strobed modules to be simultaneously loaded with the output bits stored in their corresponding output buffer registers BR-out(x) and to thereby simultaneously present those bits to those of the real pins P1-P8, P9-P16, etc., which are designated (mapped) as output pins by the direction control registers R-direct(x). (The direction control registers in combination with the tristate drivers act as a means for programmably routing output bits from the real pin registers to the real pins.)

The direction control registers R-direct(x) may be loaded sequentially in similar manner (preferably before the primary output registers are loaded with new data) using module-specific direction strobe signals LD-dir(x) for strobing the direction buffer registers BR-direct(x) of each module as the microcomputer 510 places corresponding direction control data on the emulator bus 520 to thereby load a full column (Fig. 4A) of direction control buffer registers, BR-direct(a) through BR-direct(x), with tristate driver enabling bits. By globally strobing all the primary direction registers R-direct(x) with a global direction strobe signal LD-DIR, the primary direction buffer registers R-direct(x) of all the modules M(a), M(b), . . ., etc., can be simultaneously loaded in parallel fashion with an output mapping pattern which can be used for selectively coupling target-stimulating bits of the primary output registers R-out(x) to desired ones of the real pins P1-P8, P9-P16, P17-P24, etc.

As shown in Fig. 4A, each module M(x) includes a set of eight tristate drivers D1-D8, each of which drivers has an input terminal coupled to a corresponding one of eight output terminals on the corresponding primary output register R-out(x); an output enable terminal coupled to a corresponding one of eight output terminals on the primary direction control register R-direct(x); and an output terminal coupled to a corresponding one of eight real pins P1-P8, P9-P16, etc., of the pin dummy 422. The eight real pins P1-P8 of each module M(x) are correspondingly connected to respective ones of eight input lines of the primary input registers R-in(x) of the module.

Target-produced response data, which may be simultaneously presented in parallel fashion at the pins Pl-Pn of the whole pin dummy 422 (the pin dummy as a whole is formed by modularly combining a desired number of pin modules), is simultaneously loaded into the primary input registers R-in(x) of all the modules at a preselected point in time when the data transfer sequencer 530 is commanded to issue a global load input signal LD-IN to all the modules. This parallel-loaded input data (target-produced data) is then transferred to the input buffer registers BR-in(x) of each module and from there the data is transferred to the microcomputer 510 through the emulator bus 520 by means of time multiplexing. Module-specific input load strobe signals LD-in(x) and input enable signals EN-in(x) are supplied sequentially to the modules from the data transfer sequencer 530 to effect this time multiplexed transfer over the emulator bus 520. The microcomputer 510 filters out those of the received input bits (target-produced response bits) which do not belong to real pins designated as "input pins" and the microcomputer 510 then transfers the remaining (unfiltered) N input bits according to a predetermined sequence to the soft model 312 along the serial link 340, as indicated in Fig. 3.

The ASIC emulator circuit 500 of Fig. 4A is capable of providing general purpose data exchange between the soft model 312 and the target system 424. It should be noted that the combination of the input buffer register BR-in(x) and primary input register R-in(x) of each module may be used as a two-bit long first-in/first-out (FIFO) register means for receiving bursts of data from the target system. If desired, additional input buffer registers (not shown) could be added to the combination to allow for fast reception of longer bursts. Similarly, the combination of the output buffer register BR-out(x) and primary output register R-out(x) may be used and/or expanded to provide burst mode outputs to the real pins of the pin dummy 422 if so desired. The same may be done for the direction control registers R-direct(x) and BR-direct(x) of each module if desired.

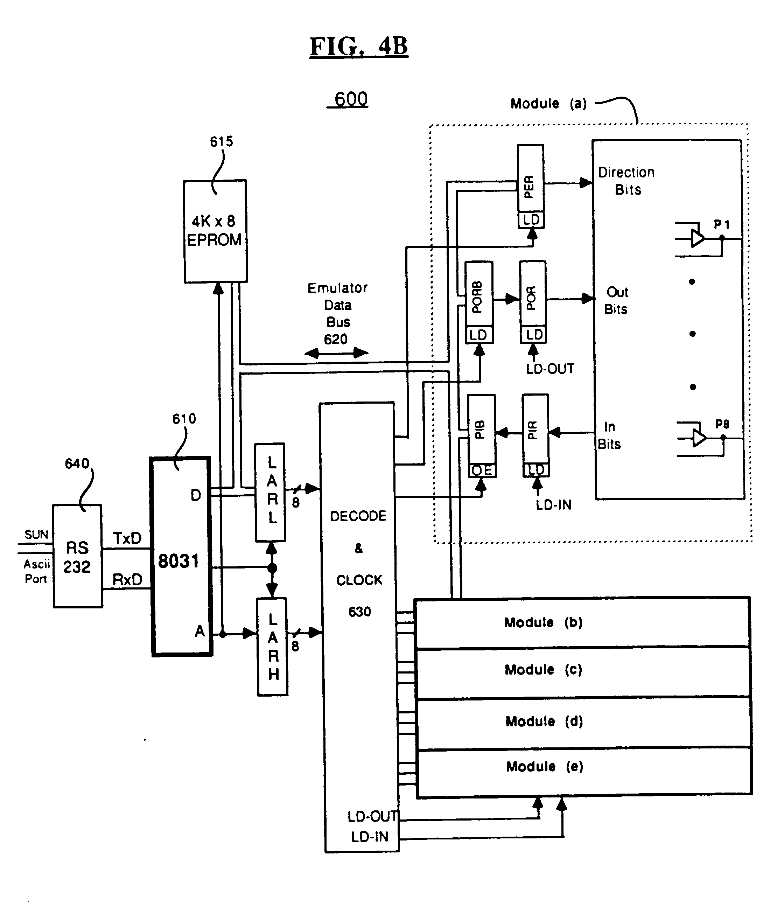

Fig. 4B shows another (scaled-down) ASIC emulator 600 which is designed for simpler modes of operation. Elements of Fig. 4B corresponding to those of Fig. 4A are denoted by like reference numerals. Microcomputer 610 is an Intel 8031™ microcontroller (available from Intel Corp. of Santa Clara, California) which is bidirectionally coupled to a Sun-4 workstation through an RS-232 serial port 640. A first eight bit wide data port D of the microcomputer 610 is coupled to a corresponding eight bit wide emulator data bus 620 of the emulator circuit 600. An eight bit wide address port A of the microcomputer is coupled to a 4Kx8 EPROM memory 615 for addressing the same and to a high byte address register LARH which is used for controlling a data transfer sequencer (Decode & Clock circuit) 630.

Each module of the second ASIC emulator 600 consists of an eight bit wide enable register PER for controlling the output enable terminals of tristate drivers D1-D8. The enable registers PER are loaded only once during module initialization and thereafter their states remain fixed. Each module also contains an eight bit wide input register PIR for receiving data from the pins of the pin dummy. Data stored in each of these input registers PIR is output to the emulator data bus 620 in time multiplexed fashion through a corresponding eight-bit-wide tristate buffer PIB. The output enable terminal OE, of each input buffer PIB, and the data load control terminal LD, of each enable register PER are activated (strobed) by suitable strobe signals generated by the data transfer sequencer 630 in a manner as substantially described before. The sequencer 630 may be formed by suitable combinatorial logic means (i.e., a gate array) for decoding command signals placed on the low and high address registers LARL and LARH thereof and for supplying strobe signals to the various modules. Each module of the simplified embodiment 600 further includes an output buffer register PORB for time-multiplexed loading of the output bits from the emulator data bus 620 to the buffer registers PORB prior to the time those bits are simultaneously (parallel-wise) loaded into the output registers POR.

As previously described, the ASIC model is often defined, at the beginning of the design/development process, in terms of a behavioral-level model or similar coarse-grained model. It can be appreciated that there will come a point in the development life of an ASIC model, when certain components thereof are defined in sufficient detail to permit their emulation in a hardware emulator. Hardware emulation of a gate-level modeled portion of the ASIC model can be carried out using programmable logic devices (PLD's) by suitable configuration of the configurable logic blocks (CLB), configurable input/output blocks (IOB's) and interconnection matrices of such devices.

Examples of PLD's are disclosed in U.S. Patent No. 4,783,607, "TTL/CMOS Compatible Input Buffer With Schmitt Trigger", which issued Nov. 8, 1988 on an application filed by Hsieh; U.S. Pat. No. 4,774,421, "Programmable Logic Array Device Using EPROM Technology", which issued Sept. 27, 1988 on an application filed by Hartmann et al; U.S. Pat. No. 4,758,985 "Microprocessor Oriented Configurable Logic Element" which issued July 19, 1988 on an application filed by Carter; U.S. Pat. No. 4,758,745, "User Programmable Integrated Circuit Interconnect Architecture and Test Method" which issued July 19, 1988 on an application filed Sept. 19, 1986 by Elgamal et. al; U.S. Pat. No. 4,713,792, "Programmable Macrocell Using EPROM or EEPROM Transistors 13 for Architecture Control in Programmable Logic Circuits" which issued Dec. 15, 1987 on an application filed by Hartmann et al; U.S. Pat. 4,706,216, "Configurable Logic Element", which issued Nov. 10, 1987 on an application filed by Carter; U.S. Pat. 4,677,318, "Programmable Logic Storage Element for Programmable Logic Devices", which issued June 30, 1987 on an application filed by Veenstra; and U.S. Pat. 4,642,487, "Special Interconnect for Configurable Logic Array" which issued Feb. 10, 1987 on an application filed by Carter. The disclosures of these patents are incorporated herein by reference.

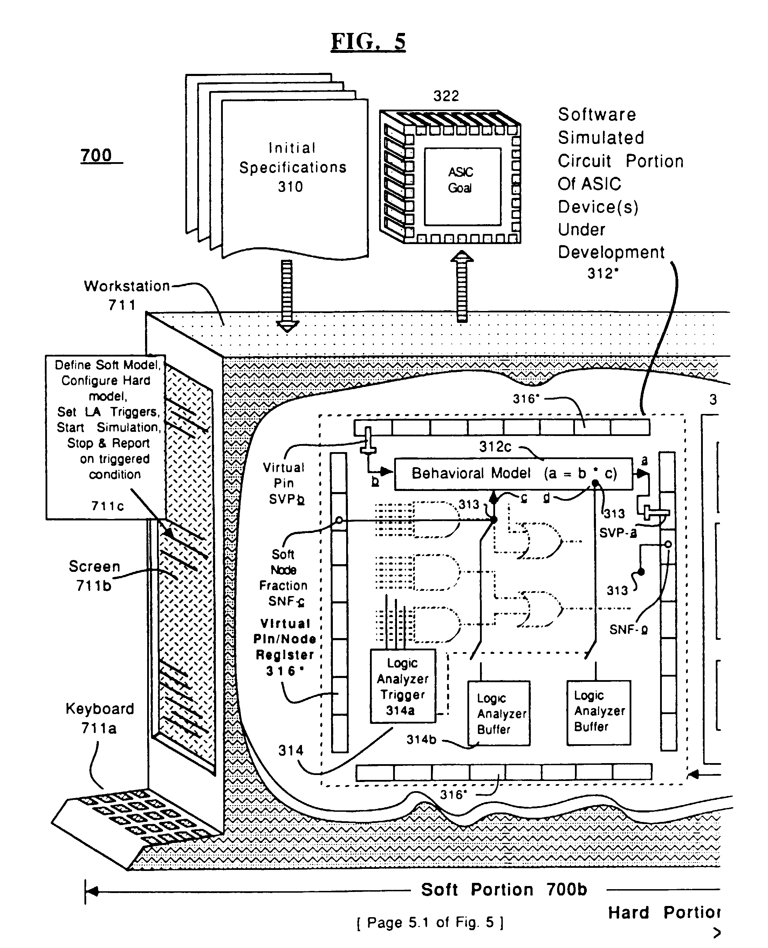

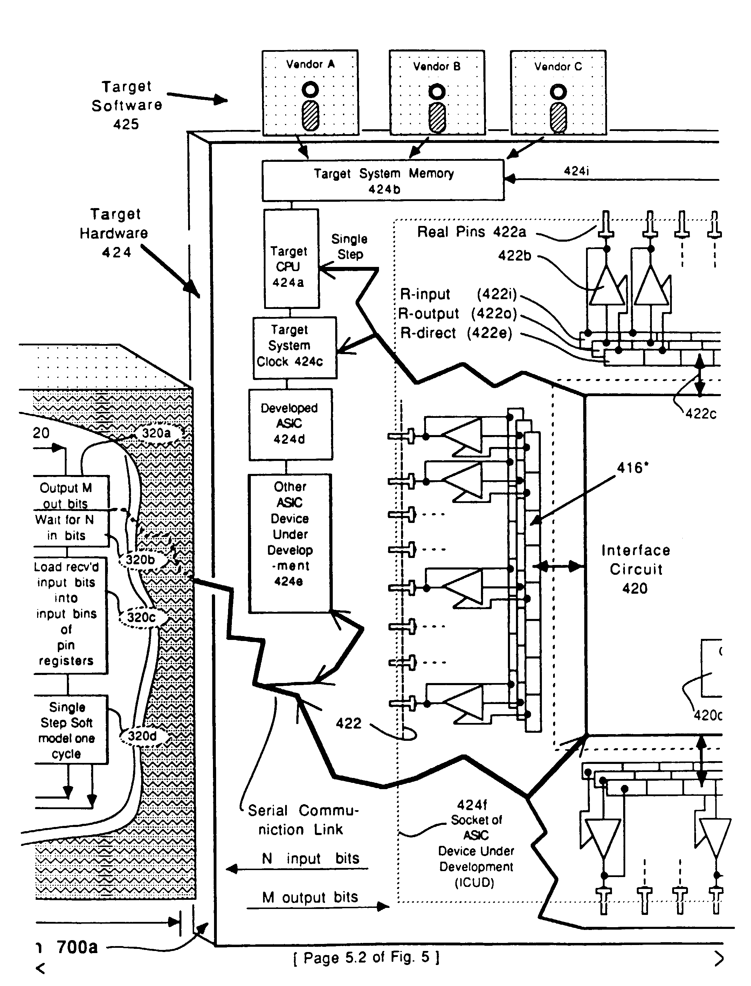

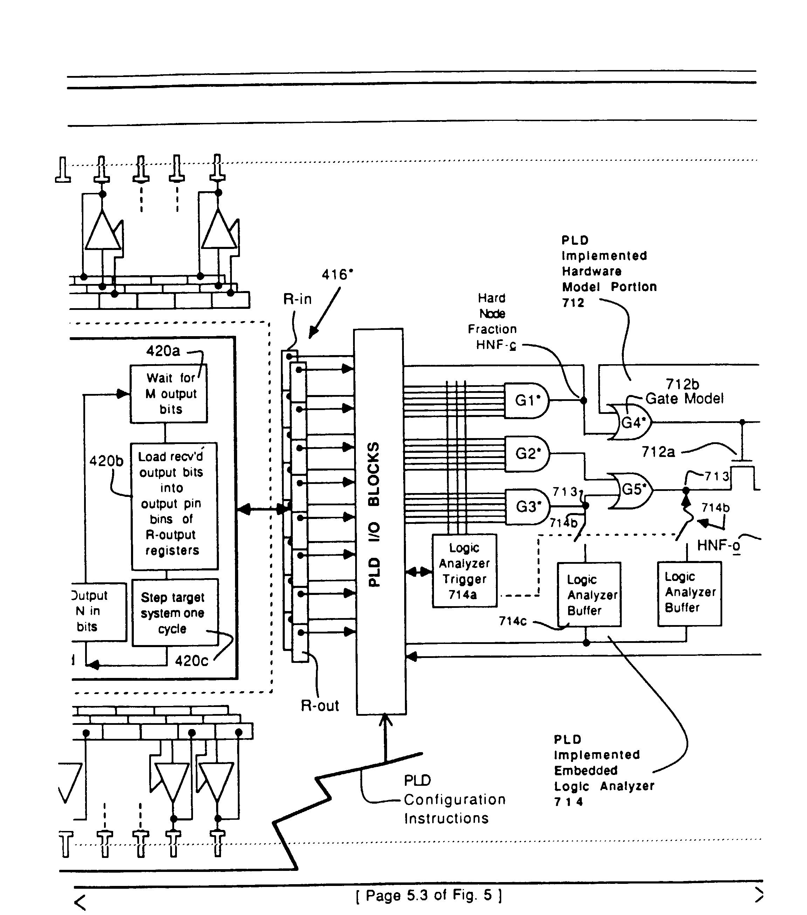

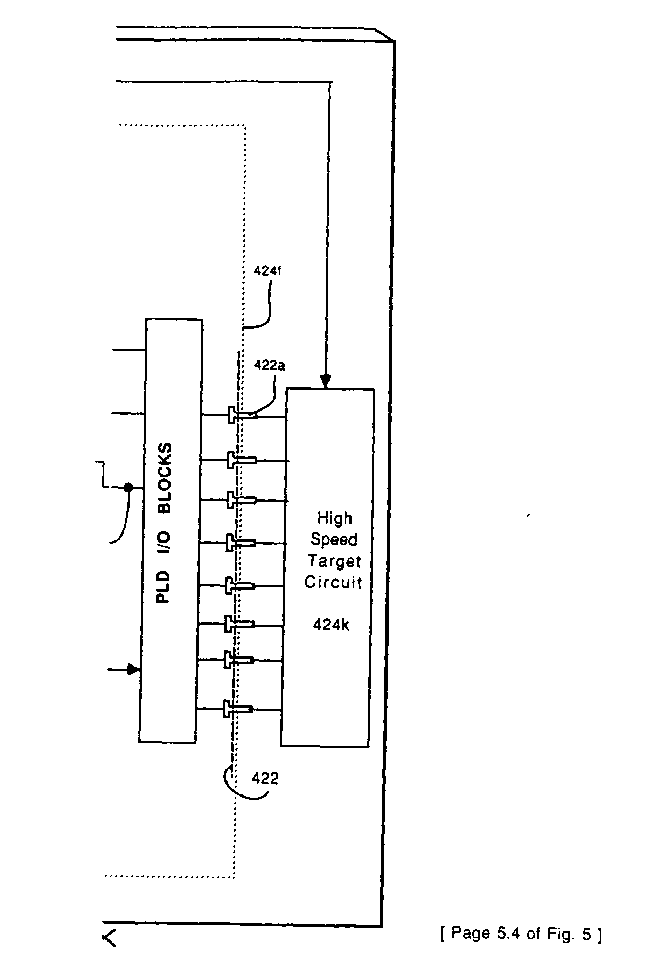

Figure 5 shows a design/development system 700 including such a PLD means 712 for hardware emulation of a gate-level portion 712b and/or a transistor-level-program 712a of the ASIC model. (Fig. 2D indicates the manner in which the four sequential pages of Fig. 5 are to be combined.) The monitoring of various test points 713 within the PLD-implemented hardware model 712 may be performed by reserving portions of each PLD IC (i.e., a Xilinx PLD chip) for implementing an embedded hardware logic analyzer 714 including logic analyzer qualifying (trigger) means 714a and by further providing embedded logic analyzer probe means 714b for coupling signal routing lines to randomly-addressable test nodes 713 within the hard model 712, and further providing logic analyzer buffer means 714c for capturing and storing data from the test nodes 713 that have been selected by the probe means 714b when appropriate triggering conditions, as set by the qualifier means 714a, are satisfied. The configurability of the PLD implemented hard model 712 may also be used for injecting test patterns into various nodes 713 thereof, again using the software controlled probe means 714b and the logic analyzer buffer means 714c.

Since portions of the overall ASIC model other than the hard model portion 712 may still be described at a less detailed level, i.e., at the behavioral level, those other portions can continue to be modeled in software by behavioral model components 312c (as previously explain) and the corresponding virtual-pin input/output states of these soft modeled portions may be projected from the virtual-pin registers 316 of the workstation 711 to mirroring real-pin registers 416* at the hardware side 700a of the overall system 700 to thereby couple the still-software-implemented soft model portion 312* with both the PLD implemented hardware model portion 712 and the pin dummy 422.

As indicated in Fig. 5 by dashed AND/OR symbols, a portion of the ASIC model originally supported in software as gate-level portion 312b (Fig. 3) has been removed from the software environment and reproduced in hardware as hardware emulated portion 712 (Fig. 5). Preferably, the hardware model portion 712 is first implemented for those portions of the ASIC model which must interface with high speed portions 424k of the target system. Newly refined portions of the ASIC model can be shifted from a software simulated mode to a hardware-emulated mode as their descriptional levels descend to the gate-level during development. It can be seen from this that the ASIC model can be easily fragmented (partitioned) into a soft model portion and a hard model portion and that the operations of both can be combined through the pin dummy.

In the partitioning of an ASIC model into soft and hard model portions (312* and 712) some nodes of the ASIC model are divided (by the partitioning) into respective soft and hard node-fractions (SNF, HNF). Similarly, it will be seen shortly that in the partitioning of a hard model portion into hard sub-portions, some "hard" nodes of the hard model portion may have to be fragmented (by the subdividing lines) into two or more corresponding hard node fractions (HNF). And in the partitioning of a soft model into soft sub-portions, it will be seen that some "soft" nodes of the soft model portion may have to be fragmented (again by the subdividing lines) into two or more corresponding soft node fractions (SNF). The term "node fraction" (NF) is used here to generically denote a first soft or hard node fraction (SNF₁/HNF₁) which has elsewhere in the ASIC model, a counterpart second soft or hard node fraction (SNF₂/HNF₂) whose states are to be real time (or pseudo-real time) mirror images (duplicates) of each other.

Referring simultaneously to both Figure 3 and Figure 5, it can be seen that the one soft node SN_{c} of Fig. 3 (feeding the operand "c" to the behavioral model of a = b * c) is partitioned in Fig. 5 into a soft node fraction SNF-c (which is shown to remain in the soft model portion 312*) and into hard node fraction HNF-c (which is shown to be implemented in the PLD-formed hard model portion 712). The virtual pin 312p feeding operand "b" to the behavioral model 312a of Fig. 3 remains in Fig. 5 as a soft virtual pin SVP-b. Soft virtual pin SVP-a remains as such in Fig. 5. The soft output pin of the transistor-level model 312a in Fig. 3 is deleted however from the soft model portion 312* of Fig. 5 and substituted for, in Fig. 5, by a soft node fraction (test-node) SFN-o in the soft portion 700b and a counterpart hard node fraction HNF-o in the PLD-implemented hard model 712. Coupling is made from hard node fraction HFN-o to a corresponding real pin of the pin dummy 422 and also to the real pin register 416* through the PLD I/O Blocks. An internal parameter, d, of the behavioral model 312c is shown to be accessible as a randomly-addressable test point 313 to the soft logic analyzer 314. Soft node fraction SNF-o is also accessible as a test point 313. It can be seen that nodes may be switched in character from being unitary wholes to being separated, but nonetheless equivalent, node fractions and from being "soft" to being "hard" as various portions of the overall ASIC model are partitioned and/or converted from being soft to being hard model portions. Moreover, every internal node of the overall ASIC model remains accessible for monitoring by an embedded logic analyzer means (i.e., 314 and 714).

Referring to another design/development system 800 shown in Fig. 6A, it should now become apparent that the ASIC model can be further fragmented so that behavioral level components thereof can be mapped into a massively parallel array of processors 880 (each comprising a microcomputer module µC and memory module, Mem) in similar fashion to the way that gate-level and transistor-level modeled portions thereof 312b, 312a can be mapped into an array of PLD's 870. A combination of PLD's 870 and parallel processors 880 may be used for simulating, at high speed, preselected portions of the ASIC model. Certain portions of the ASIC model may continue to be simulated in a von-Neumann style workstation 311* if so desired. The workstation 311* is provided with a virtual pin/node register means 316* and the embodiment 800 is provided with a counterpart pin/node register means 816 which is operated to create a real/pseudo-real time equivalency relationship between "soft" pins/nodes supported by the virtual pin/node register means 316* and counterpart pins/nodes supported by the latter register means 816. Besides functioning to simulate a von-Neumann style, soft model portion of the ICUD and to create a mirror image relation between the data in the virtual pin/node register means 316* and counterpart pin/node register means 816, the workstation 311* may be further used as a means for controlling the monitoring of various test nodes within a PLD array implemented hardware model portion 870 or within a parallel processor array implemented behavioral model portion 880. Again, suitable logic analyzer/test pattern injector means are provided in the software/hardware environment of the parallel processor array 880 for capturing data during prespecified qualification periods and transmitting the captured data to the workstation 311* for subsequent analysis. Interconnections between the fragmented portions of the ASIC model can be made using a software responsive array of multiplexers 822 (shown schematically as an interconnection gridwork) or other suitable signal routing means.

The software responsive signal routing means 822 is used to selectively interconnect the counterpart pin/node register means 816, the PLD array 870, and the parallel processor array 880 one to the other and further to an umbilical cable 422u extending from the pin dummy 422 and further to a serial to parallel converter means 820. Portions 820, 822, 816, 870 and 880 are denoted in Fig. 6A as belonging to a hard/soft model portion support-platform (H/S-MPSP) 800a.

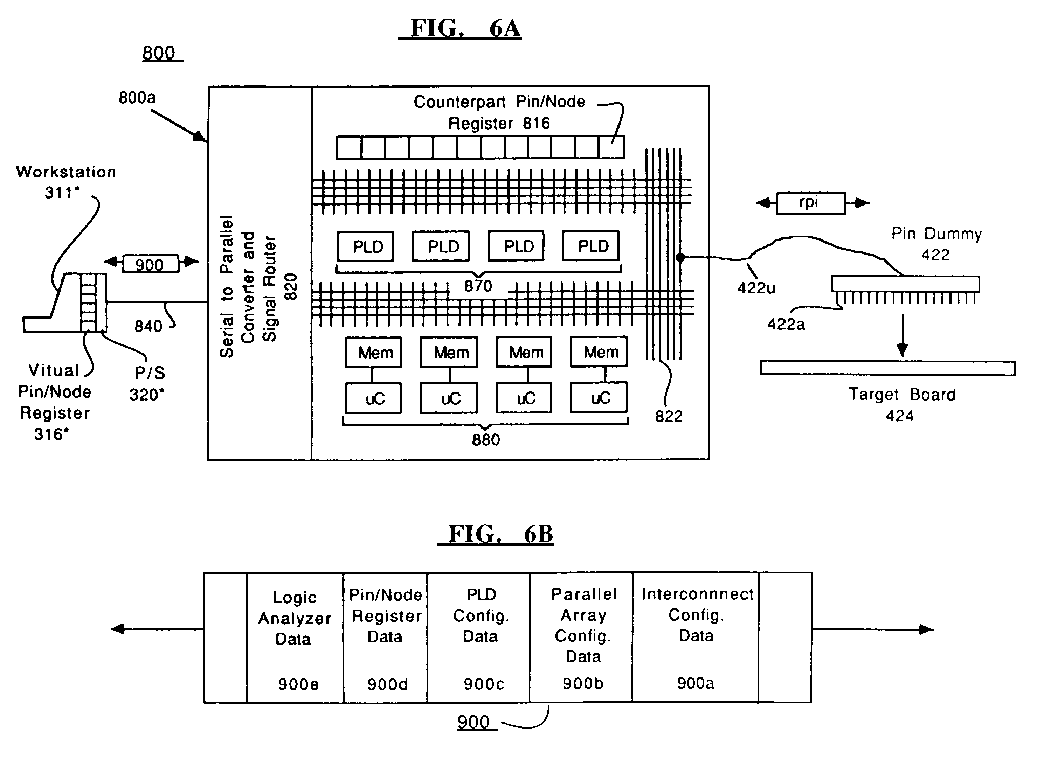

The serial to parallel converter means 820 receives packets of information 900 transmitted along communication link 840 (from a corresponding parallel to serial converting means 320 in the work station) and routes such data, in a predetermined manner, to configure the programmable interconnect means 822 in accordance with interconnect configuration data 900a included in the transmitted information packets 900 (refer to Fig. 6B), to configure the parallel processor array 880 in accordance with parallel array configuration data 900b, thereby to program the parallel processor array 880 for simulating preselected portions of the ASIC model; to configure the PLD array 870 in accordance with PLD configuration data 900c transmitted thereto for creating in the PLD array 870 a hard model portion of the ASIC model; and for shuttling pin/node equilibrating (mirroring) information back and forth between the virtual pin/node register means 316* and the counterpart pin/node register means 816 of the system 800. The serial to parallel means 820 is further used for shuttling back and forth between the workstation and the H/S MPSP 800a, embedded logic analyzer configuration data and logic analyzer report data 900e. A block diagram of the shuttled information 900 is shown in Fig. 6B.

In the embodiment 800 of Fig. 6A, pin states stored in the counterpart pin/node register means 816 do not necessarily have to correspond to all the states of the real pins 422a on the pin dummy 422. Rather, the memory cells of the counterpart pin/node register means 816 may be coupled to either soft or hard and further whole or fractioned nodes which are contained (supported) somewhere within the overall design/development system 800. Real pin information (rpi) is shuttled back and forth through umbilical cable 422u to create mirror relations between real pins 422a of dummy 422 and corresponding node fractions (not shown) supported by either or both of H/S-MPSP 800a and workstation 311*.

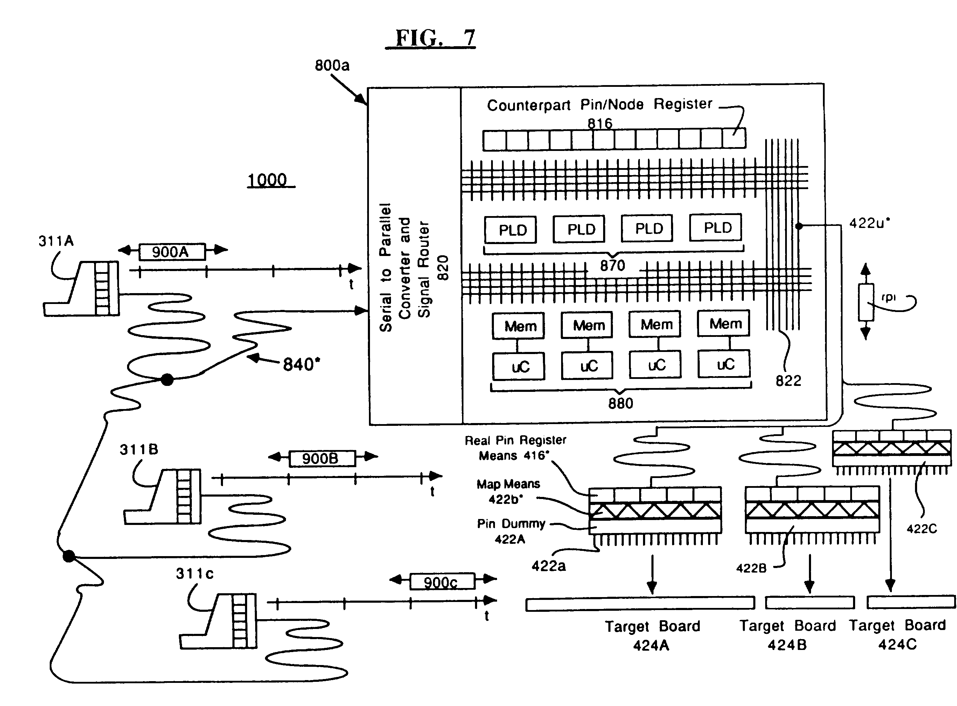

Until now, it has been assumed that the information packets 900 arriving at the head end 820 of H/S-MPSP 800a are all coming from a single work station 311* as shown in Fig. 6A. But there is no such requirement. Referring to the embodiment 1000 shown in Fig. 7, it can be seen that time multiplexed information packets 900A, 900B, 900C, etc. may be received from individual work stations 311A, 311B, 311C, etc. at different points in time, t, as schematically shown in Fig. 7, and that these separate packets of information 900A-900C may be combined in a serial communication network 840*, passed through the H/S-MPSP 800a and from there the hard image of a first virtual ASIC may be projected through a first pin dummy 422A into a first target board 424A. Moreover, the respective hard images of second, third, etc. virtual ASIC may be projected through second, third, etc. pin dummies 422B, 422C, etc. into respective second, third, etc., target boards, 424B, 424C, etc. and the responses of the target boards 424A-424C may be likewise reflected back to plural ASIC models which are supported by the combination (not necessarily respective) of workstations 311A-311C and H/S-MPSP 800a.

The term "virtual ASIC" is used here to denote an ASIC model which is defined either in whole or in part by a soft model portion and/or a hard model portion. 1n the design development system 1000 shown Fig. 7, each of a plurality of virtual ASICs may be randomly partitioned into ASIC model portions and these model portions may be each supported by a different work station 311A, 311B, 311C, etc. or by one or more H/S-MPSP modules 800a, all of which are interconnected through the communication network 840*. This network-distributed design/development system 1000 allows different portions (sub-models) of an ASIC design to be developed in parallel at different development sites and for the developed sub-models of these different development sites to be combined simultaneously to create a hard image of a virtual ICUD that is defined by an arbitrary combination of the sub-models, at the ASIC receiving socket of a particular target board 424A-424C (which boards, incidentally, can be located at different sites).

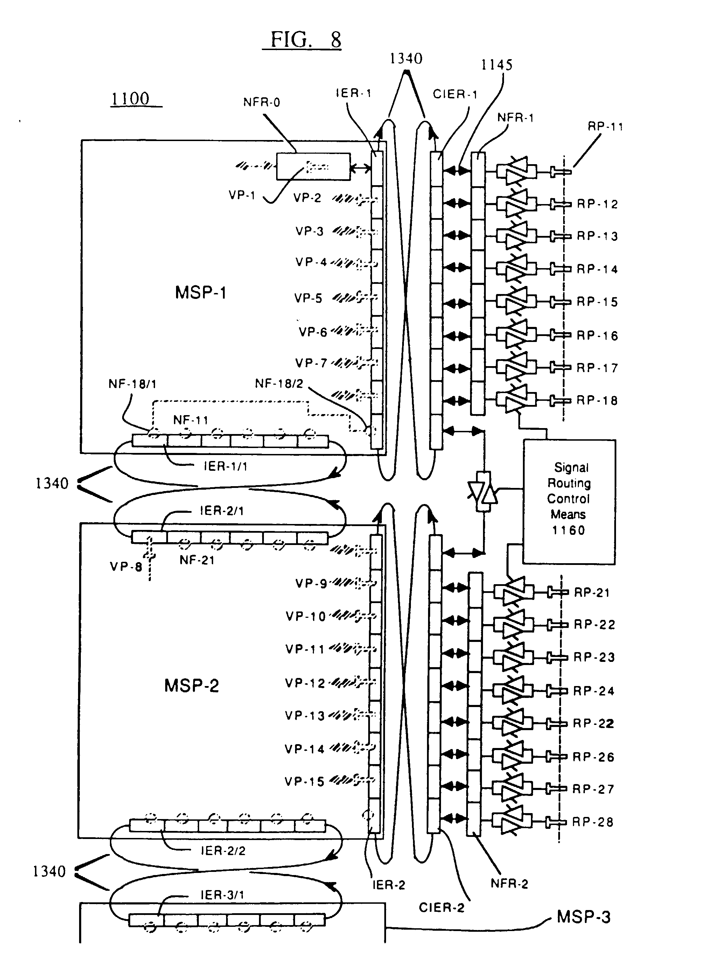

Referring to Fig. 8, there is shown a block diagram of yet another network-coupled method for combining ASIC sub-models to thereby project through one or more pin dummies 422A-422C, the real image of one or more virtual ASICs. In the embodiment 1100 of Fig. 8, the distinction between hard "virtual" pins and soft "virtual" pins is blurred, they are referred to generically as virtual pins VP-x (x being an arbitrary number). The distinction between hard and soft model support platforms is also blurred. Both types are denoted simply as model (or sub-model) support platforms, MSP-x. Data contained in the memory cells of each of the illustrated primary and complementary information-exchange registers, IER-1, CIER-1, IER-2, CIER-2, etc., may represent the logic states of any of a virtual node which is simulated in the soft sub-model of a virtual ASIC, a virtual interpackage connection within such an ASIC, and a "real" node within a hardware emulated sub-model portion of the virtual ASIC.

The virtual ASIC of Fig. 8 is partitioned and distributed among spaced apart sub-model support platforms, MSP-1, MSP-2 and MSP-3. Each of these sub-model support platforms MSP-x includes at least one node fraction supporting register, i.e., NFR-0 (only one shown) for simulating or emulating a node. The node fraction registers (only NFR-0 shown and the rest implied to be supporting other NF's of the MSP's) are each respectively coupled by means of a primary information exchange register, i.e. IER-1, and a complementary information exchange register, i.e. CIER-1, to a complementary (mirror image) node fraction register, i.e. NFR-1. Each of the illustrated primary and complementary information exchange registers, IER-x and CIER-x (x being an arbitrary number), can be formed of a serial shift register or other suitable serial/parallel conversion means for serially exchanging information across serial communication links 1340 in such a manner as to create a mirror image relationship between the data contained in the node fraction registers (only one, NFR-0, shown) of the sub-model support platforms MSP-x and their corresponding node fraction registers NFR-1, NFR-2 in the ASIC emulating module in accordance with the techniques described previously. The complementary information exchange registers CIER-x of the ASIC emulating module are each correspondingly coupled by parallel exchange lines 1145 to corresponding (real) node fraction registers NFR-x and the later are coupled by means of suitable transceivers 1150 to the real pins RP-x of one or more pin dummies 422. The signal conducting directions, if any, of the transceivers are controlled by signal routing control means 1160.

Aside from the information exchange which takes place between the node registers (only one cell, NFR-0, shown) of each of the sub-model support platforms MSP-x, information exchange may further take place between secondary information-exchange registers, ie.., IER-1/1 to IER-2/1, of each support platgorm to thereby replicate the states of partitioned ASIC nodes other than pin nodes in each of the corresponding sub-models.

The information exchange arrangement of Fig. 8 permits designers at different locations to develop different portions of an ASIC model and allows these designers to combine their respective portions-in-development with corresponding portions-in-development of other designers, even when the other designers are located relatively far away from the first designers, so that interactions between the various portions of the ASIC under development and its target system and/or systems may be observed in either real time or pseudo-real time.

Those skilled in the art will appreciate that the above described methodologies for developing application specific integrated circuits in combination with target systems may be provided in may different forms and many variations.

## Claims

1. A method for developing at different sites different portions of a single integrated circuit (322) which is to be inserted into a target system, said method comprising the steps of:
partitioning the integrated circuit (322) into model portions;
modeling each model portion on its own support platform (MSP-1), either in software or in hardware, at different locations;
providing on each support platform a virtual-pin register means (IER-1) and an information exchange register means (IER-1/1);
providing a real-pin register means (CIER-1), representing the physical pins of said integrated circuit in the target system, for collecting pin information from individual ones of the modelled portions; and
exchanging across a communication link means (1340) information:
a) between said virtual-pin register means (IER-1) of the model portions and the real-pin register means (CIER-1) so as to establish a mirror relationship between the logic states of the real-pin register means and the virtual-pin register means of the modelled portions of the integrated circuit; and
b) between said information exchange register means (IER-1/1; IER-2/1) of two support platforms to thereby replicate the states of nodes other than pin nodes partitioned between the two respective models.

2. The method of claim 1, wherein said step of modeling is performed by using software models programmed on a computer (311).

3. The method of claim 1, wherein said step of modeling is performed by using programmable logic devices (422).

4. The method of claim 1, wherein said step of modeling is performed by using a combination of software models programmed on a computer (711) and programmable logic devices (422).

5. The method of claim 1, wherein said step of modeling uses a behavioral-level model of said model portions (312).

6. The method of claim 1, wherein each model portion (312) is modeled in parallel on a plurality of workstations (311a-c) connected by a local area network (840).

7. The method of claim 1, further comprising the steps of:
connecting said real-pin register means to a target system (424);
stepping said model portions by a predetermined number of cycles to generate logic states at said virtual pin nodes (316); and
stepping said target system (424) by a predetermined number of cycles to generate logic states at said real-pin register means.

8. The method of claim 3, where said programmable logic device (422) comprises
a first portion for emulating said model portion (712); and
a second portion containing logic analyzer circuitry (714) for monitoring behaviour at a test node (713) in said model portion (712).

9. The method of claim 5, wherein said behavioral-level model is defined in software using a computer (311).

## Patentansprüche

1. Verfahren zur Entwicklung verschiedener Teile einer einzigen integrierten Schaltung (322), die in ein Zielsystem eingeschoben werden soll, an verschiedenen Orten, wobei das Verfahren folgende Schritte umfaßt:
Aufteilen der integrierten Schaltung (322) in Modellteile;
Modellierung jedes Modellteils auf seiner eigener Trägerplattform (MSP-1), entweder in Software oder Hardware, an verschiedenen Orten;
Bereitstellen einer viertuellen Anschlußstiftregistervorrichtung (IER-1) und einer Informationsaustauschregistervorrichtung (IER-1/1) auf jeder Trägerplattform;
Bereitstellen einer realen Anschlußstiftregistervorrichtung (CIER-1), die die physischen Anschlußstifte der integrierten Schaltung im Zielsystem darstellt, um Anschlußstiftinformation von den einzelnen modellierten Teilen zu sammeln; und
Austauschen von Information über eine Kommunikationsverbindungsvorrichtung (1340):
a) zwischen der virtuellen Anschlußstiftregistervorrichtung (IER-1) der Modellteile und der realen Anschlußstiftregistervorrichtung (CIER-1), um eine spiegelbildliche Beziehung zwischen den logischen Zuständen der realen Anschlußstiftregistervorrichtung und der virtuellen Anschlußstiftregistervorrichtung der modellierten Teile der integrierten Schaltung zu errichten; und
b) zwischen der Informationsaustauschregistervorrichtung (IER-1/1, IER-2/1) zweier Trägerplattformen, um somit die Zustände der Knoten nachzubilden, die nicht zwischen den jeweiligen zwei Modellen aufgeteilte Anschlußstiftknoten sind.

2. Verfahren nach Anspruch 1, wobei der Schritt der Modellierung unter Verwendung von Softwaremodellen, die auf einem Rechner (311) programmiert sind, durchgeführt wird.

3. Verfahren nach Anspruch 1, wobei der Schritt der Modellierung durch Verwendung programmierbarer logischer Vorrichtungen (422) durchgeführt wird.

4. Verfahren nach Anspruch 1, wobei der Schritt der Modellierung unter Verwendung einer Kombination von Softwaremodellen, die auf einem Rechner (711) programmiert sind und programmierbaren logischen Vorrichtungen (422) durchgeführt wird.

5. Verfahren nach Anspruch 1, wobei der Schritt der Modellierung ein Verhaltensebenenmodell der Modellteile (312) verwendet.

6. Verfahren nach Anspruch 1, wobei jeder Modellteil (312) parallel auf einer Vielzahl von Arbeitsplätzen (311a-c), die durch ein lokales Netz (840) verbunden sind, modelliert wird.

7. Verfahren nach Anspruch 1, wobei sie weiter folgende Schritte umfaßt:
Verbinden der realen Anschlußstiftregistervorrichtung mit einem Zielsystem (424);
Weiterschalten der Modellteile um eine vorbestimmten Anzahl von Zyklen, um logische Zustände an den virtuellen Anschlußstiftknoten (316) zu erzeugen; und
Weiterschalten des Zielsystems (424) um eine vorbestimmte Anzahl von Zyklen, um logische Zustände an der realen Anschlußstiftregistervorrichtung auszubilden.

8. Verfahren nach Anspruch 3, wobei die programmierbare logische Vorrichtung (422) folgendes umfaßt:
einen ersten Teil für das Emulieren des Modellteils (712); und
einen zweiten Teil, der eine Logikanalysatorschaltung (714) zur Überwachung des Verhaltens an einem Testknoten (713) in diesem Modellteil (712) enthält.

9. Verfahren nach Anspruch 5, wobei das Verhaltensebenenmodell mittels Software unter Verwendung eines Rechners (311) festgelegt wird.

## Revendications

1. Procédé pour développer, au niveau de différents sites, des parties différentes d'un seul circuit intégré (322) qui est à insérer dans un système cible, ledit procédé comprenant les étapes suivantes :
le partage du circuit intégré (322) en parties formant modèle ;
la modélisation de chaque partie formant modèle sur sa propre plate-forme de support (MSP-1), soit par logiciel soit par matériel, au niveau d'endroits différents ;
l'installation sur chaque plate-forme de support de moyens de registre de broches virtuelles (IER-1) et de moyens de registre d'échange d'informations (IER-1/1) ;
l'installation de moyens de registre de broches réelles (CIER-1), représentant les broches physiques dudit circuit intégré dans le système cible, pour recueillir des informations concernant les broches en provenance de parties individuelles des parties modélisées ; et
l'échange d'informations sur des moyens de liaison de télécommunications (1340) :
a) entre lesdits moyens de registre de broches virtuelles (IER-1) des parties formant modèle et les moyens de registre de broches réelles (CIER-1), de façon à établir une relation de miroir entre les états logiques des moyens de registre de broches réelles et les moyens de registre de broches virtuelles des parties modélisées du circuit intégré ; et
b) entre lesdits moyens de registre d'échange d'informations (IER-1/1; IER-2/1) de deux plates-formes de support pour dupliquer, de ce fait, les états de noeuds autres que les noeuds de broches partagées entre les deux modèles respectifs.

2. Procédé selon la revendication 1, dans lequel ladite étape de modélisation est effectuée en utilisant des modèles logiciels programmés sur un ordinateur (311).

3. Procédé selon la revendication 1, dans lequel ladite étape de modélisation est effectuée en utilisant des dispositifs à logique programmable (422).

4. Procédé selon la revendication 1, dans lequel ladite étape de modélisation est effectuée en utilisant une combinaison de modèles logiciels programmés sur un ordinateur (711) et de dispositifs à logique programmable (422).

5. Procédé selon la revendication 1, dans lequel ladite étape de modélisation utilise un modèle de niveau comportemental desdites parties formant modèle (312).

6. Procédé selon la revendication 1, dans lequel chaque partie formant modèle (312) est modélisée parallèlement sur une pluralité de postes de travail (311 a à c) reliés par un réseau local (840).

7. Procédé selon la revendication 1, comprenant de plus les étapes suivantes :
la connexion desdits moyens de registre de broches réelles à un système cible (424) ;
la progression pas à pas desdites parties formant modèle par un nombre prédéterminé de cycles pour produire des états logiques au niveau desdits noeuds de broches virtuelles (316) ; et
la progression pas à pas dudit système cible (424) par un nombre prédéterminé de cycles pour produire des états logiques au niveau desdits moyens de registre de broches réelles.

8. Procédé selon la revendication 3, dans lequel ledit dispositif à logique programmable (422) comprend :
une première partie pour émuler ladite partie formant modèle (712) ; et
une seconde partie contenant des circuits d'analyseur logique (714) pour surveiller le comportement au niveau d'un noeud de contrôle (713) dans ladite partie formant modèle (712).

9. Procédé selon la revendication 5, dans lequel ledit modèle comportemental est défini par logiciel en utilisant un ordinateur (311).
